# EUROPEAN PATENT SPECIFICATION

(11) **EP 4 503 887 B1**
(45) Date of publication and mention of the grant of the patent: **05.08.2026**
(21) Application number: 24182388.9
(22) Date of filing: 14.06.2024
(51) Int. Cl.: H10B 63/00

(54) **MULTI-BLOCK THREE-DIMENSIONAL SEMICONDUCTOR MEMORY DEVICE**
DREIDIMENSIONALE MULTIBLOCK-HALBLEITERSPEICHERANORDNUNG
DISPOSITIF DE MÉMOIRE SEMI-CONDUCTEUR TRIDIMENSIONNEL À MULTI-BLOCS

(30) Priority: 01.08.2023 KR 20230100705
(43) Date of publication of application: 05.02.2025
(73) Proprietor: Samsung Electronics Co., Ltd., Suwon-si, Gyeonggi-do 16677 (KR)
(72) Inventor: KOO, Bonjae, 16677 Suwon-si (KR); SONG, Seulji, 16677 Suwon-si (KR); SONG, Youngsun, 16677 Suwon-si (KR)
(74) Representative: Marks & Clerk LLP

(56) References cited:
- US-A1- 2012 147 644
- US-A1- 2013 187 118
- US-B1- 10 170 570

## Description

### BACKGROUND

The present disclosure relates to a semiconductor memory device, and more particularly, to a three-dimensional vertical memory device.

High-capacity semiconductor memory devices are required as electronic products to be miniaturized and multifunctional, and have high performance, and increased integration is required to provide high-capacity semiconductor memory devices. Because the degree of integration of two-dimensional (2D) semiconductor memory devices is mainly determined by an area occupied by unit memory cells, the degree of integration of two-dimensional semiconductor memory devices is increasing but is still limited. Accordingly, a three-dimensional (3D) vertical memory device in which memory capacity is increased by stacking a plurality of memory cells in a vertical direction on a substrate has been proposed.

US2013/0187118A1 describes a memory device including first and second interconnect groups and memory cells, according to the preamble of independent claim 1.

US10170570B1 describes a semiconductor memory device including a plurality of stacked electrodes extending in a first direction and a second direction orthogonal to the first direction, and including opposed sides extending in the second direction.

US2012/147644A1 describes a three-dimensional array adapted for memory elements that reversibly change a level of electrical conductance in response to a voltage difference being applied across them.

### SUMMARY

One or more embodiments provide a three-dimensional vertical memory device with improved integration.

According to an aspect of an embodiment, a semiconductor memory device includes: a plurality of cell blocks, each including a folding structure in which a plurality of electrode structures and a plurality of insulating structures are alternately provided, wherein each of the plurality of electrode structures and each of the the plurality of insulating structures extend in a vertical direction and are connected with each other so as to have at least two U-shaped structures in a plan view, the plurality of electrode structures include a vertical electrode and a switching material layer, and the plurality of cell blocks are provided in a first horizontal direction and a second horizontal direction intersecting the first horizontal direction; and a gate stack structure including a plurality of gate electrodes and a plurality of interlayer insulating layers that are alternately stacked in the vertical direction along sidewalls of the plurality of electrode structures. Each of the plurality of gate electrodes includes a pad part and a plurality of plate electrodes spaced apart from each other in a horizontal direction, and at least one plate electrode among the plurality of plate electrodes is connected to the switching material layer of the plurality of electrode structures in each of two of the plurality of cell blocks in the first horizontal direction and at least two of the plurality of cell blocks in the second horizontal direction.

At least some of the above and other features of the invention are set out in the claims.

### BRIEF DESCRIPTION OF DRAWINGS

The above and other aspects and features will be more apparent from the following description of embodiments, taken in conjunction with the accompanying drawings, in which:
FIGS. 1A, 1B and 1C are a plan view, a cross-sectional view, and a perspective view of a semiconductor memory device according to an embodiment;
FIGS. 2A, 2B and 2C are a plan view, a cross-sectional view, and a perspective view of a semiconductor memory device according to an embodiment;
FIGS. 3A, 3B and 3C are a plan view, a cross-sectional view, and a perspective view of a semiconductor memory device according to an embodiment;
FIGS. 4A, 4B and 4C are a plan view, a cross-sectional view, and a perspective view of a semiconductor memory device according to an embodiment;
FIGS. 5A and 5B are a plan view and a block diagram of a semiconductor memory device according to an embodiment;
FIGS. 6A and 6B are plan views of a semiconductor memory device according to an embodiment;
FIGS. 7A and 7B are a plan view and a block diagram of a semiconductor memory device according to an embodiment;
FIGS. 8A and 8B are plan views of a semiconductor memory device according to an embodiment;
FIGS. 9A and 9B are a plan view and a block diagram of a semiconductor memory device according to an embodiment; and
FIG. 10 is a plan view of a semiconductor memory device according to an embodiment.

### DETAILED DESCRIPTION

Hereinafter, embodiments will be described in detail with reference to the accompanying drawings. Embodiments described herein are example embodiments, and thus, the present disclosure is not limited thereto, and may be realized in various other forms. Each embodiment provided in the following description is not excluded from being associated with one or more features of another example or another embodiment also provided herein or not provided herein but consistent with the present disclosure. It will be understood that when an element or layer is referred to as being "on," "connected to" or "coupled to" another element or layer, it can be directly on, connected or coupled to the other element or layer, or intervening elements or layers may be present. By contrast, when an element is referred to as being "directly on," "directly connected to" or "directly coupled to" another element or layer, there are no intervening elements or layers present. As used herein, the term "and/or" includes any and all combinations of one or more of the associated listed items. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c. It will be also understood that, even if a certain step or operation of manufacturing an apparatus or structure is described later than another step or operation, the step or operation may be performed later than the other step or operation unless the other step or operation is described as being performed after the step or operation. The same reference numerals are used for the same components in the drawings, and redundant descriptions thereof are omitted. In the following detailed description and claims, it will be understood that, although the terms first, second, etc. may be used herein to describe various elements, these elements should not be limited by these terms. These terms are only used to distinguish one element from another.

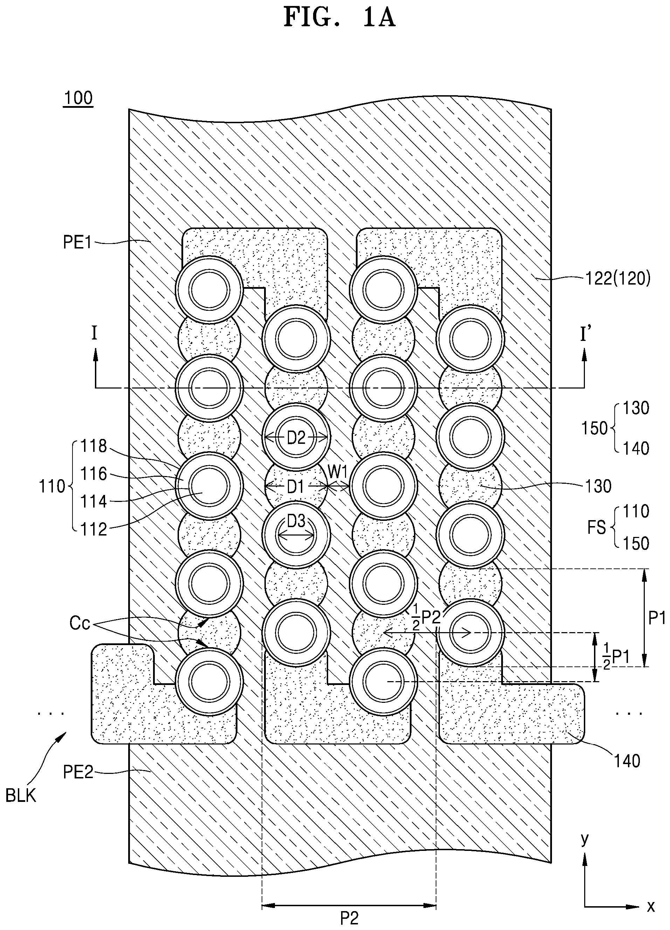

FIGS. 1A to 1C are a plan view, a cross-sectional view, and a perspective view of a semiconductor memory device according to an embodiment.

Referring to FIGS. 1A to 1C, a semiconductor memory device 100 according to an embodiment may include a substrate 101, a plurality of electrode structures 110, a gate stack structure 120, and a plurality of insulating structures 150. In one cell block BLK included in the semiconductor memory device 100, a plurality of electrode structures 110 and a plurality of insulating structures 150 may be alternately arranged along a path with a U-shaped structure that forms a villus shape in a plan view. That is, the plurality of electrode structures 110 and the plurality of insulating structures 150 may form a villus shape of a U-shaped pattern in a plan view. The plurality of electrode structures 110 and the plurality of insulating structures 150 included in one cell block BLK may be alternately arranged to have at least two U-shaped structures forming villus shapes in a plan view, and may be connected to each other to constitute a folding structure FS. The folding structure FS may be arranged such that at least two insulating structures 150, each of which are protrusions of villus shapes, face the second horizontal direction (y direction) or the reverse direction of the second horizontal direction (y direction). Although FIG. 1A illustrates that the folding structure FS has two U-shaped structures forming villus shapes, the folding structure FS is not limited thereto. For example, the folding structure FS may have U-shaped structures forming more than two villus shapes. The plurality of insulating structures 150 may include a plurality of partition wall pillars 130 and a plurality of trim patterns 140.

The substrate 101 may have a plurality of cell regions and a plurality of pad regions alternately arranged in the first horizontal direction (x direction), and the cell regions are illustrated in FIGS. 1A to 4C. The first horizontal direction (x direction) and the second horizontal direction (y direction) may be orthogonal to each other. The substrate 101 may include silicon (Si), for example, single crystalline Si, polycrystalline Si, or amorphous Si. Of course, the material of the substrate 101 is not limited to Si. For example, in some embodiments, the substrate 101 may include a group IV semiconductor such as germanium (Ge), a group IV-IV compound semiconductor such as silicon germanium (SiGe) or a silicon carbide (SiC), or a group III-V compound semiconductor such as gallium arsenide (GaAs), indium arsenide (InAs), or indium phosphate (InP).

The substrate 101 may be based on a silicon bulk substrate. In addition, the substrate 101 may be based on a silicon-on-insulator (SOI) substrate or a germanium-on-insulator (GeOI) substrate. The substrate 101 may be a substrate based on an epitaxial wafer, a polished wafer, an annealed wafer, or the like, and is not limited to a bulk substrate, an SOI or GeOI substrate. The substrate 101 may include a conductive region, for example, an impurity-doped well, or various structures doped with impurities. In addition, the substrate 101 may constitute a P-type substrate or an N-type substrate according to the type of doped impurity ions.

In some embodiments, a peripheral circuit and a wiring layer connected to the peripheral circuit may be arranged on a partial region of the substrate 101. The peripheral circuit may receive addresses, commands, and control signals from devices outside the semiconductor memory device 100, and may transmit and receive data to and from the devices outside the semiconductor memory device 100. The peripheral circuit may include a row decoder, a page buffer, a data input/output circuit, and a control logic. In some embodiments, the peripheral circuit may further include an input/output interface, a column logic, a voltage generator, a pre-decoder, a temperature sensor, a command decoder, an address decoder, an amplification circuit, and the like.

As illustrated in FIG. 1A, a plurality of electrode structures 110 may be arranged in a two-dimensional array structure on an x-y plane. Specifically, the plurality of electrode structures 110 may be spaced apart from each other in the first horizontal direction (x direction) and the second horizontal direction (y direction). The electrode structures 110 form a line in the second horizontal direction (y direction), and the electrode structures 110 adjacent to each other in the second horizontal direction (y direction) may be separated from each other by partition wall pillars 130. In addition, the electrode structures 110 constituting two lines adjacent to each other in the first horizontal direction (x direction) may be connected to gate electrodes 122 of the gate stack structures 120.

The electrode structures 110 constituting the line in the second horizontal direction (y direction) may be arranged in a zigzag shape in the second horizontal direction (y direction) on two lines adjacent to each other in the first horizontal direction (x direction). For example, the electrode structures 110 may be arranged with a first pitch P1 in the second horizontal direction (y direction), and the electrode structures 110 may be arranged with an offset of 1/2 of the first pitch P1 in the second horizontal direction (y direction) between two adjacent lines in the first horizontal direction (x direction). For example, the electrode structures 110 may be arranged with a second pitch P2 in the first horizontal direction (x direction), and the electrode structures 110 may be arranged with an offset of 1/2 of the second pitch P2 in the first horizontal direction (x direction) between two adjacent lines in the second horizontal direction (y direction). In some embodiments, the first pitch P1 and the second pitch P2 may have substantially the same value.

The electrode structure 110 may have a cylindrical shape extending in a direction perpendicular to the top surface of the substrate 101, that is, in a vertical direction (z direction). However, the shape of the electrode structure 110 is not limited to the cylindrical shape. For example, in some embodiments, the electrode structure 110 may have the shape of an elliptical column or a polygonal column.

Each of the electrode structures 110 may include a vertical electrode 112, a first selection electrode layer 114, a switching material layer 116, and a second selection electrode layer 118, which may be sequentially provided from the center thereof. In some embodiments, at least one of the first selection electrode layer 114 and the second selection electrode layer 118 may be omitted. In the semiconductor memory device 100, the vertical electrode 112 may form a vertical bit line. Each of the first selection electrode layer 114 and the second selection electrode layer 118 may be made of a conductive material, for example, carbon or a conductive material containing carbon. The switching material layer 116 may include a material having ovonic threshold switching (OTS) characteristics.

The vertical electrode 112 may have a cylindrical shape extending in a vertical direction (z direction) on the top surface of the substrate 101. However, the shape of the vertical electrode 112 is not limited to the cylindrical shape. For example, the vertical electrode 112 may have a shape of an elliptical column or a polygonal column. The vertical electrode 112 may include a conductive material. For example, the vertical electrode 112 may include doped polysilicon, metal, conductive metal nitride, or a combination thereof. In some embodiments, a conductive contact connected to the vertical electrode 112 may be arranged under and/or above the electrode structure 110.

The first selection electrode layer 114 may cover a bottom surface and a side surface of the vertical electrode 112. For example, the first selection electrode layer 114 may have a cylindrical pipe shape with a closed bottom surface. However, in some embodiments, the first selection electrode layer 114 may have an open cylindrical pipe shape.

The switching material layer 116 may cover bottom and side surfaces of the first selection electrode layer 114. Accordingly, the switching material layer 116 may have a cylindrical pipe shape with one side closed. However, in some embodiments, the switching material layer 116 may have an open cylindrical pipe shape.

The switching material layer 116 may serve as a self-selective storage element. Here, the self-selective storage element may mean an element capable of acting as both a selection element and a storage element. The semiconductor memory device 100 may be a three-dimensional vertical memory device including a selector only memory (SOM) device or a self-selective memory (SSM) device.

The switching material layer 116 may include a chalcogenide material such as a chalcogenide alloy and/or chalcogenide glass that serves as a self-selective storage device. The switching material layer 116 may respond to an applied voltage such as a program pulse. For example, for an applied voltage less than a threshold voltage, the switching material layer 116 may be kept in an electrically non-conductive state, that is, in an "off" state. In addition, in response to an applied voltage greater than a threshold voltage, the switching material layer 116 may be changed to an electrically conductive state, that is, an "on" state. The threshold voltage of the switching material layer 116 may be changed based on the polarity of the applied voltage. The threshold voltage of the switching material layer 116 may be changed according to whether the polarity of the program pulse is positive or negative. For example, the semiconductor memory device 100 may require a bipolar voltage to drive a memory device.

The switching material layer 116 may include a chalcogenide material having a phase that does not change during operation. For example, the switching material layer 116 may be made of a single layer or a multilayer made of a material selected from two component system materials such as GeSe, GeS, AsSe, AsTe, AsS, SiTe, SiSe, SiS, GeAs, SiAs, SnSe, SnTe, three component system materials such as GeAsTe, GeAsSe, AlAsTe, AlAsSe, SiAsSe, SiAsTe, GeSeTe, GeSeSb, GaAsSe, GaAsTe, InAsSe, InAsTe, SnAsSe, SnAsTe, four component system materials such as GeSiAsTe, GeSiAsSe, GeSiSeTe, GeSeTeSb, GeSiSeSb, GeSiTeSb, GeSeTeBi, GeSiSeBi, GeSiTeBi, GeAsSeSb, GeAsTeSb, GeAsTeBi, GeAsSeBi, GeAsSeIn, GeAsSeGa, GeAsSeAl, GeAsSeTl, GeAsSeSn, GeAsSeZn, GeAsTeIn, GeAsTeGa, GeAsTeAl, GeAsTeTl, GeAsTeSn, GeAsTeZn, five component system materials such as GeSiAsSeTe, GeAsSeTeS, GeSiAsSeS, GeSiAsTeS, GeSiSeTeS, GeSiAsSeP, GeSiAsTeP, GeAsSeTeP, GeSiAsSeIn, GeSiAsSeGa, GeSiAsSeAl, GeSiAsSeTl, GeSiAsSeZn, GeSiAsSeSn, GeSiAsTeIn, GeSiAsTeGa, GeSiAsTeAl, GeSiAsTeTl, GeSiAsTeZn, GeSiAsTeSn, GeAsSeTeIn, GeAsSeTeGa, GeAsSeTeAl, GeAsSeTeTl, GeAsSeTeZn, GeAsSeTeSn, GeAsSeSIn, GeAsSeSGa, GeAsSeSAl, GeAsSeSTl, GeAsSeSZn, GeAsSeSSn, GeAsTeSIn, GeAsTeSGa, GeAsTeSAl, GeAsTeSTl, GeAsTeSZn, GeAsTeSSn, GeAsSeInGa, GeAsSeInAl, GeAsSeInTl, GeAsSeInZn, GeAsSeInSn, GeAsSeGaAl, GeAsSeGaTl, GeAsSeGaZn, GeAsSeGaSn, GeAsSeAlTl, GeAsSeAlZn, GeAsSEAlSn, GeAsSeTlZn, GeAsSeTlSn, GeAsSeZnSn, and six component system materials such as GeSiAsSeTeS, GeSiAsSeTeIn, GeSiAsSeTeGa, GeSiAsSeTeAl, GeSiAsSeTeTl, GeSiAsSeTeZn, GeSiAsSeTeSn, GeSiAsSeTeP, GeSiAsSeSIn, GeSiAsSeSGa, GeSiAsSeSAl, GeSiAsSeSTl, GeSiAsSeSZn, GeSiAsSeSSn, GeAsSeTeSIn, GeAsSeTeSGa, GeAsSeTeSAl, GeAsSeTeSTl, GeAsSeTeSZn, GeAsSeTeSSn, GeAsSeTePIn, GeAsSeTePGa, GeAsSeTePAl, GeAsSeTePTl, GeAsSeTePZn, GeAsSeTePSn, GeSiAsSeInGa, GeSiAsSeInAl, GeSiAsSeInTl, GeSiAsSeInZn, GeSiAsSeInSn, GeSiAsSeGaAl, GeSiAsSeGaTl, GeSiAsSeGaZn, GeSiAsSeGaSn, GeSiAsSeAlSn, GeAsSeTeInGa, GeAsSeTeInAl, GeAsSeTeInTl, GeAsSeTeInZn, GeAsSeTeInSn, GeAsSeTeGaAl, GeAsSeTeGaTl, GeAsSeTeGaZn, GeAsSeTeGaSn, GeAsSeTeAlSn, GeAsSeSInGa, GeAsSeSInAl, GeAsSeSInTl, GeAsSeSInZn, GeAsSeSInSn, GeAsSeSGaAl, GeAsSeSGaTl, GeAsSeSGaZn, GeAsSeSGaSn, GeAsSeSAlSn. In some embodiments, the switching material layer 116 may each include at least one material selected from the two component system materials to the six component system materials illustrated above and at least one additional element selected from B, C, N, and O.

The second selection electrode layer 118 may cover bottom and side surfaces of the switching material layer 116. Accordingly, the second selection electrode layer 118 may have a cylindrical pipe shape with a closed bottom surface. However, in some embodiments, the second selection electrode layer 118 may have an open cylindrical pipe shape.

For reference, when a conductive contact is arranged under the electrode structure 110, and when the first selection electrode layer 114, the switching material layer 116, and the second selection electrode layer 118 have a cylindrical pipe structure with a closed bottom surface, the conductive contact may penetrate the first selection electrode layer 114, the switching material layer 116, and the second selection electrode layer 118 to be connected to the vertical electrode 112. Alternatively, when the first selection electrode layer 114, the switching material layer 116, and the second selection electrode layer 118 have an open cylindrical pipe structure without a bottom surface, the conductive contact may be directly connected to the vertical electrode 112.

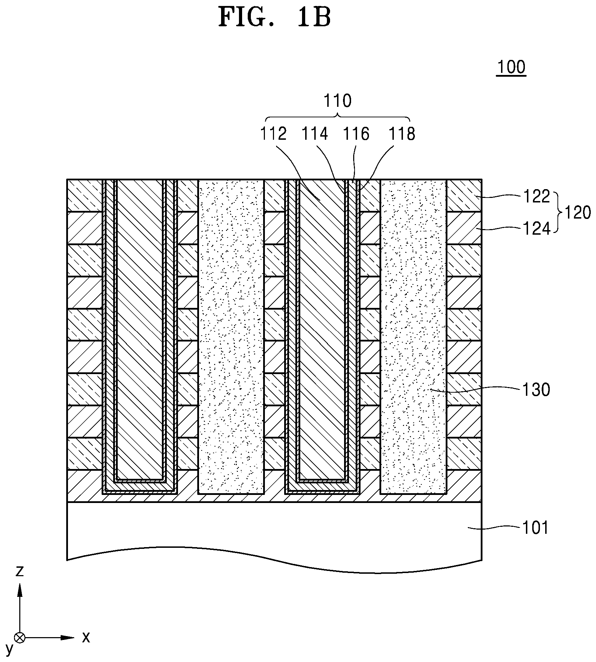

The gate stack structure 120 may include a plurality of gate electrodes 122 and a plurality of interlayer insulating layers 124. As illustrated in FIG. 1B, the plurality of gate electrodes 122 and the plurality of interlayer insulating layers 124 may be alternately stack on the substrate 101 along the sidewalls of the electrode structure 110. In the semiconductor memory device 100, the gate electrodes 122 may constitute a word line.

Each of the plurality of gate electrodes 122 may have a plate shape. The plurality of gate electrodes 122 may be spaced apart from each other in a vertical direction (z direction). In this regard, the gate electrodes 122 in each layer may have a structure integrally connected to each other in a plate shape. Accordingly, the gate electrode 122 may be referred to as a plate electrode. In addition, in some embodiments, the gate electrode 122 may be referred to as a word line plate.

In the semiconductor memory device 100, the gate electrode 122 may have a shape of a split plate electrode. For example, in each layer, the gate electrode 122 may include a first plate electrode PE1 on one side (up in FIG. 1A) in the second horizontal direction (y direction) and a second plate electrode PE2 on the other side (down in FIG. 1A). In addition, the first plate electrode PE1 and the second plate electrode PE2 may have the form of a staggered comb. For example, the first plate electrode PE1 and the second plate electrode PE2 may be arranged on both sides in the first horizontal direction (x direction) based on any one line in which the electrode structures 110 are arranged in the second horizontal direction (y direction). Each of the first plate electrode PE1 and the second plate electrode PE2 may include sawtooth parts extending into villus shapes of the folding structure FS, connected to the electrode structures 110 and extending in the second horizontal direction (y direction), and shaft parts extending in the first horizontal direction (x direction).

In the semiconductor memory device 100, because the gate electrode 122 has a split plate electrode shape, it is possible to improve the operation speed by minimizing a parasitic capacitance on a word line. In addition, because the gate electrode 122 has a split plate electrode shape, it is possible to increase a programming current by minimizing an area in contact with a cell and reducing cell leakage.

The gate electrode 122 may include a conductive material, for example, doped silicon, metal, conductive metal nitride, conductive metal silicide, conductive metal oxide, or a combination thereof. The interlayer insulating layer 124 may include an insulating material, for example, silicon oxide, silicon nitride, silicon oxynitride, or the like. In the semiconductor memory device 100, the interlayer insulating layer 124 may include silicon oxide. However, the material of the interlayer insulating layer 124 is not limited to silicon oxide. For example, the interlayer insulating layer 124 may be made of an insulating material having a dielectric constant lower than silicon oxide. In some embodiments, the interlayer insulating layer 124 may consist of a tetraethyl orthosilicate (TEOS) layer or an ultra low K (ULK) layer having an ultra low dielectric constant K of about 2.2 to about 2.4. The ULK layer may include a SiOC layer or a SiCOH layer.

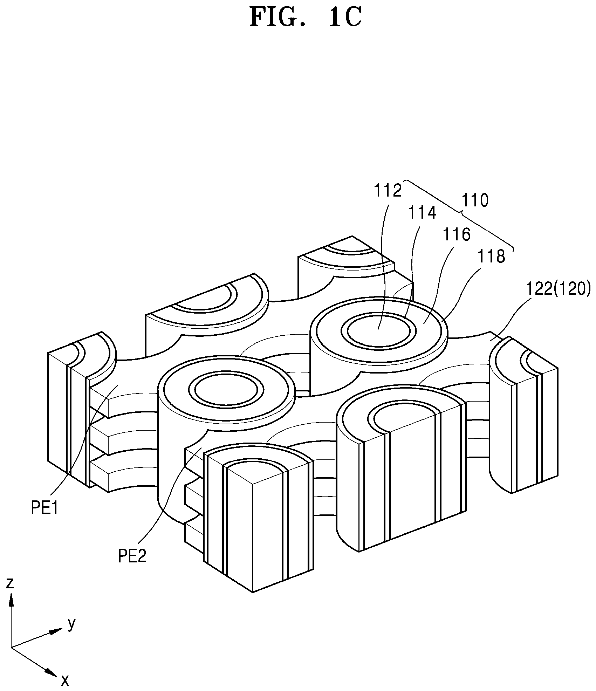

Each of a plurality of partition wall pillars 130 may be arranged between the electrode structures 110 arranged in the second horizontal direction (y-direction). The partition wall pillars 130 may extend in a vertical direction (z direction). The partition wall pillar 130 has a substantially cylindrical shape, but some of the outer parts may be invaded by electrode structures 110 arranged on both sides in the second horizontal direction (y direction). Accordingly, the partition wall pillars 130 may include concave portions Cc at both sides in the second horizontal direction (y-direction). The partition wall pillar 130 may include an insulating material, for example, silicon oxide, silicon nitride, or silicon oxynitride. In the semiconductor memory device 100, the partition wall pillars 130 may include silicon oxide. However, the material of the partition wall pillars 130 is not limited to silicon oxide. For reference, the interlayer insulating layers 124 and the partition wall pillars 130 are omitted in FIG. 1C, and empty spaces between the electrode structures 110 in the second horizontal direction (y direction) may correspond to the partition wall pillars 130, and empty spaces between the gate electrodes 122 in the vertical direction (z direction) may correspond to the interlayer insulating layers 124.

A plurality of trim patterns 140 may be arranged on both edge portions of the cell block BLK in the second horizontal direction (y-direction). The trim patterns 140 may extend in the vertical direction (z direction). Each of a plurality of insulating structures 150 including the plurality of partition wall pillars 130 and the plurality of trim patterns 140 may extend in the vertical direction (z direction). Here, the cell blocks BLK may be defined by a folding structure FS composed of the plurality of electrode structures 110 and the plurality of insulating structures 150 alternately arranged and connected to each other to have at least two U-shaped structures formed of villus-shapes in a plan view. In this regard, one cell block BLK may include one folding structure FS. For example, each of the folding structures FS spaced apart from each other in a plan view may constitute a separate cell block BLK.

In some embodiments, the cell block BLK may extend in the first horizontal direction (x direction), a step-shaped pad may be arranged at an edge portion of the cell block BLK in the first horizontal direction (x direction), and a vertical contact may be connected to the pad. A word line voltage may be applied to the gate electrode 122 of each layer through the vertical contact and the pad. For example, a pad connected to the first plate electrode PE1 and a pad connected to the second plate electrode PE2 may be respectively arranged at both edge portions of the cell block BLK in the first horizontal direction (x direction). In some embodiments, the first plate electrode PE1 and the pad connected to the first plate electrode PE1 may have an integral plate electrode shape, and the second plate electrode PE2 and the pad connected to the second plate electrode PE2 may have an integral plate electrode shape. The plate electrode in which the first plate electrode PE1 and the pad connected to the first plate electrode PE1 forms one body, and the plate electrode in which the second plate electrode PE2 and the pad connected to the second plate electrode PE2 forms one body may be spaced apart from each other.

The trim patterns 140 may each have an L shape in a plan view. In this regard, the trim patterns 140 may each include a portion that extends in the first horizontal direction (x direction) and a portion that extends in the second horizontal direction (y direction). In addition, the trim patterns 140 may each have a width covering the two adjacent partition wall pillars 130 in the first horizontal direction (x direction). That is, among the lines in which the electrode structures 110 are arranged in the second horizontal direction (y direction), two lines adjacent in the first horizontal direction (x direction) may be in contact with trim patterns 140 arranged below or above in the second horizontal direction (y direction) through the electrode structures 110. The trim patterns 140 below in the second horizontal direction (y direction) and the trim patterns 140 above in the second horizontal direction (y direction) may be arranged at alternating positions along the second horizontal direction (y direction). In addition, two trim patterns 140 facing each other in the second horizontal direction (y direction) and adjacent to each other in the first horizontal direction (x direction) may cover one line in which electrode structures 110 are arranged together in the second horizontal direction (y direction), and may be arranged in a point-symmetric structure based on any one part on the line, for example, the electrode structure 110 of the central part on the line.

The trim patterns 140 may include an insulating material, for example, silicon oxide, silicon nitride, or silicon oxynitride. In the semiconductor memory device 100, the plurality of trim patterns 140 may be formed together with the plurality of partition wall pillars 130, and the plurality of partition wall pillars 130 and the plurality of trim patterns 140 may be referred to as the plurality of insulating structures 150. For example, the trim patterns 140 may each include silicon oxide. However, the materials of the trim patterns 140 are not limited to silicon oxide.

The partition wall pillar 130 may have a first diameter D1, and the electrode structure 110, including a second selection electrode layer 118, may have a second diameter D2. The vertical electrode 112 may have a third diameter D3. The third diameter D3 may have a value smaller than each of the first diameter D1 and the second diameter D2. In some embodiments, the first diameter D1 and the second diameter D2 may have substantially the same value. For example, when each of the first pitch P1 and the second pitch P2 is about 160 nm, each of the first diameter D1 and the second diameter D2 may be about 120 nm, the third diameter D3 may be about 60 nm, and the first width W1 of the gate electrode 122 between the electrode structure 110 and the partition wall pillar 130 in the first horizontal direction (x direction) may be about 40 nm.

In the semiconductor memory device 100, the plurality of electrode structures 110, each having a vertical electrode 112 and a switching material layer 116, may extend in a vertical direction, and the plurality of gate electrodes 122 may have a vertical structure of being stacked in a vertical direction (z direction) along the sidewalls of the plurality of electrode structures 110. Accordingly, the semiconductor memory device 100 may implement a large-capacity memory device with an increased degree of integration. In addition, in the semiconductor memory device 100, the gate electrode 122 may have a shape of a split plate electrode. Accordingly, the semiconductor memory device (100) of this embodiment may increase an operation speed by minimizing a parasitic capacitance, and may increase a programming current by reducing cell leakage by minimizing an area in contact with a cell. Furthermore, in the semiconductor memory device 100 of this embodiment, the electrode structures 110 are arranged in a line shape in the second horizontal direction (y direction), and may be separated from each other by cylindrical partition wall pillars 130. As described above, because the cylindrical partition wall pillars 130 have a structure arranged between the electrode structures 110, it is possible to effectively prevent a leaning defect that may occur while forming a line pattern having a high aspect ratio in the gate stack structures 120 of tens to hundreds of layers.

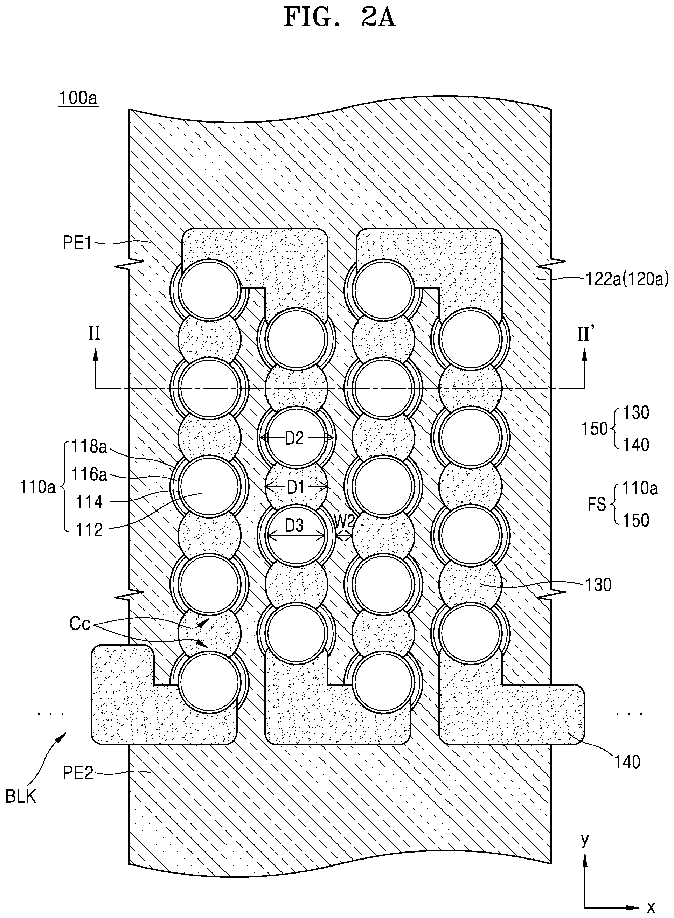

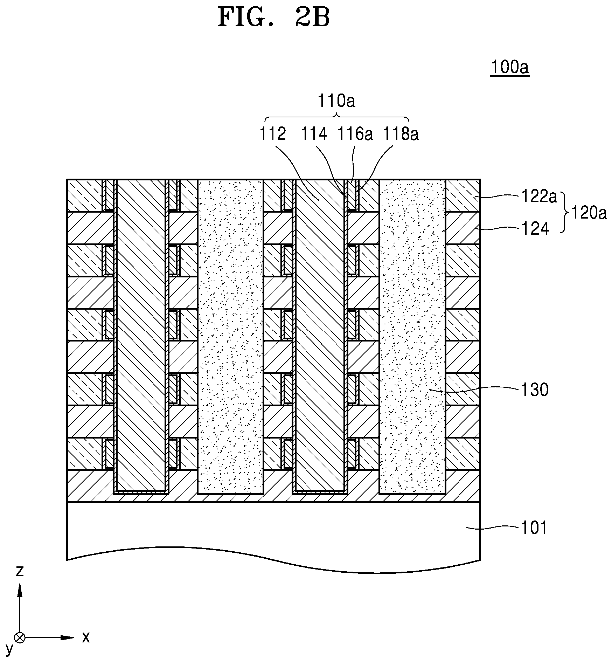

FIGS. 2A to 2C are a plan view, a cross-sectional view, and a perspective view of a semiconductor memory device according to an embodiment. In FIGS. 2A to 2C, redundant description to those described with reference to FIGS. 1A to 1C will be briefly described or omitted.

Referring to FIGS. 2A to 2C, a configuration of the electrode structure 110a of the semiconductor memory device 100a may be different from a configuration of the electrode structure 110 of the semiconductor memory device 100 of FIG. 1A. Specifically, the semiconductor memory device 100a may include a substrate 101, a plurality of electrode structures 110a, a gate stack structure 120a, and a plurality of insulating structures 150. The substrate 101, the gate stack structure 120a, and the insulating structures 150 are the same as described in the substrate 101, the gate stack structure 120, and the insulating structures 150 of the semiconductor memory device 100 of FIG. 1A. However, in the case of the gate stack structure 120a, the width of the gate electrode 122a in the first horizontal direction (x direction) may be narrower than the gate electrode 122 of FIG. 1A at a portion in contact with the electrode structure 110a. The width of the gate electrode 122a will be described in more detail below in the description of the electrode structure 110a.

As illustrated in FIG. 2A, the electrode structures 110a may be arranged in a two-dimensional array structure on an x-y plane. Specifically, the electrode structures 110a form a line in the second horizontal direction (y direction), and may be separated from each other by partition wall pillars 130 in the second horizontal direction (y direction). In addition, the electrode structures 110a on two lines adjacent to each other in the first horizontal direction (x direction) may be connected to gate electrodes 122a of the gate stack structures 120a. In addition, the electrode structures 110a constituting the line in the second horizontal direction (y direction) may be arranged in a zigzag shape in the second horizontal direction (y direction) on two lines adjacent to each other in the first horizontal direction (x direction), and may have an offset of 1/2 pitch in the second horizontal direction (y direction).

Each of the electrode structures 110a may include a vertical electrode 112, a first selection electrode layer 114, a switching material layer 116a, and a second selection electrode layer 118a. In some embodiments, at least one of the first selection electrode layer 114 and the second selection electrode layer 118a may be omitted.

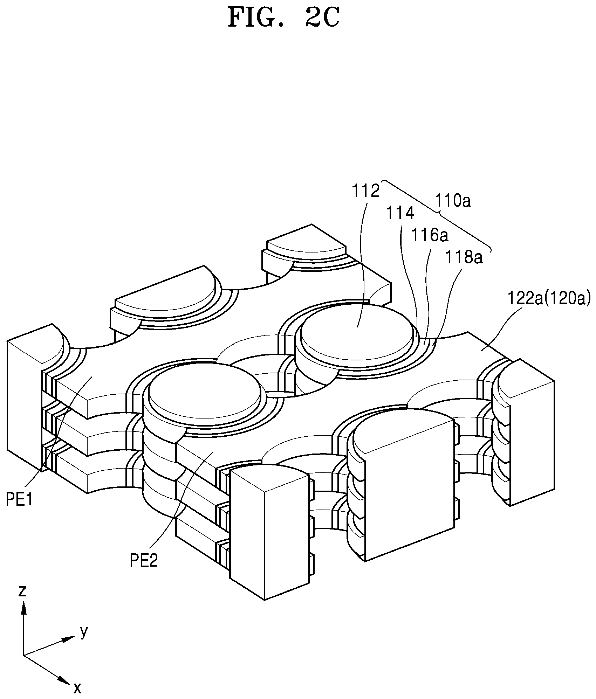

A switching material layer 116a may include a plurality of switching elements spaced apart from each other for each layer in the vertical direction (z direction) on the substrate 101. Each of the switching elements may have two arc shapes facing each other and surrounding a portion of the first selection electrode layer 114. For example, the switching elements of the switching material layer 116a may be arranged in an arc shape only on the layers where the gate electrode 122a of the gate stack structure 120a is located. Specifically, as can be seen from FIGS. 2A and 2C, each of the switching elements of the switching material layer 116a may have a circular ring shape surrounding the first selection electrode layer 114 without a portion in contact with both partition wall pillars 130 in the second horizontal direction (y direction). For example, side surfaces of the arc shapes may face partition wall pillars 130. Accordingly, the first selection electrode layer 114 may be in contact with the partition wall pillar 130 in the second horizontal direction (y-direction). The switching elements of the switching material layer 116a may be separated from the switching elements of other layers in the vertical direction (z direction).

Because the switching material layer 116a has switching elements that are separated from each other in the vertical direction (z direction), diffusion between cells is blocked in the vertical direction (z direction), thereby improving the reliability of the semiconductor memory device 100a. In addition, the operation characteristics and specific materials of the switching material layer 116a are the same as those described in the switching material layer 116 of the semiconductor memory device 100 in FIG. 1A.

The second selection electrode layer 118a may include a plurality of electrode elements spaced apart from each other for each layer in the vertical direction (z direction) corresponding to the switching elements of the switching material layer 116a. Each of the electrode elements may have two arc shapes surrounding the switching elements of the corresponding switching material layer 116a. Specifically, as can be seen from FIGS. 2A and 2C, because the electrode elements of the second selection electrode layer 118a and the switching elements of the switching material layer 116a have two arc shapes, the first selection electrode layer 114 may be in contact with both partition wall pillars 130 in the second horizontal direction (y direction). Similar to the switching material layer 116a, the electrode elements of the second selection electrode layer 118a may be also separated from the electrode elements of other layers in the vertical direction (z direction).

When an open hole for forming the electrode structure 110a has the same size as an open hole for forming the electrode structure 110 in the semiconductor memory device 100 of FIG. 1A, and when the thicknesses of the first selection electrode layers 114, the switching material layers 116 and 116a, and the second selection electrode layers 118 and 118a of the electrode structures 110 and 110a are the same, respectively, the size of the vertical electrode 112 of the electrode structure 110a, for example, the horizontal radius, may be larger than the horizontal radius of the vertical electrode 112 of the electrode structure 110 of FIG. 1A, due to the characteristics of the process. For example, when the second selection electrode layers 118 and 118a are very thin, the horizontal radius of the vertical electrode 112 of the electrode structure 110a may be almost similar to the horizontal radius of the entire electrode structure 110a. In addition, as the switching material layer 116a and the second selection electrode layer 118a of the electrode structure 110a are arranged in two arc shapes at both sides in the first horizontal direction (x direction), the gate electrode 122a of the gate stack structure 120a may have a narrower width in the first horizontal direction (x direction) at a portion in contact with the electrode structure 110a, for example, the second selection electrode layer 118a.

The partition wall pillars 130 may each have a first diameter D1, and the electrode structures 110a may each have a second diameter D2' excluding the second selection electrode layer 118a. The vertical electrode 112 may have a third diameter D3. The third diameter D3 may have a value smaller than each of the first diameter D1 and the second diameter D2'. In some embodiments, the first diameter D1 and the second diameter D2' may have substantially the same value. A second width W2 of the gate electrode 122a between the electrode structure 110a and the partition wall pillar 130 in the first horizontal direction (x direction) may be smaller than the first width W1 of the gate electrode 122 shown in FIG. 1A. For example, the second width W2 may be less than the first width W1 as much as the thickness of the second selection electrode layer 118a.

Like the semiconductor memory device 100 of FIG. 1A, the semiconductor memory device 100a of this embodiment may have increased integration, improved operation speed, increased programming current, and reduced leaning defects. In addition, the semiconductor memory device 100a has a structure in which the switching elements of the switching material layer 116a are separated from each other in the vertical direction (z direction), thereby blocking diffusion between cells and improving the reliability of the memory device.

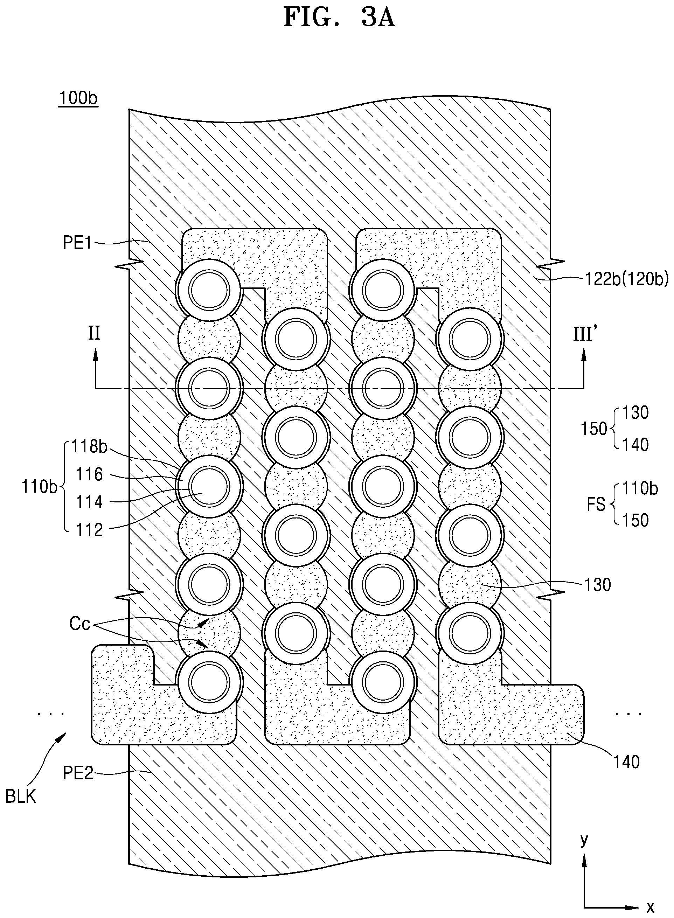

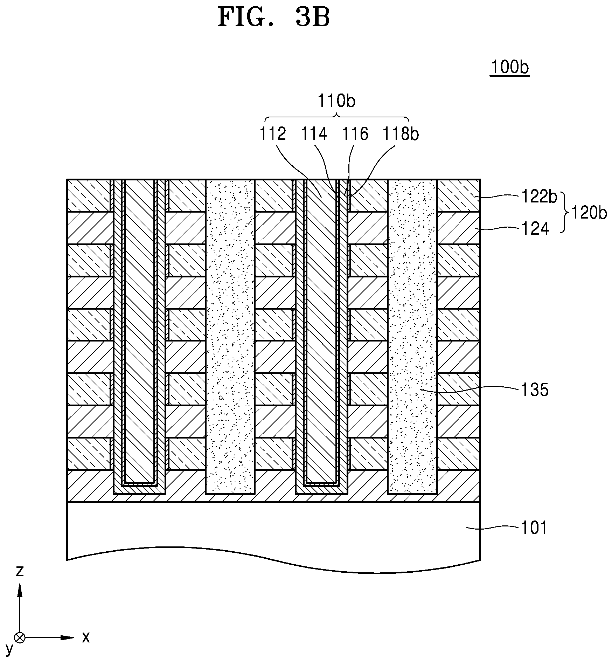

FIGS. 3A to 3C are a plan view, a cross-sectional view, and a perspective view of a semiconductor memory device according to an embodiment. In FIGS. 3A to 3C, redundant description to those described with reference to FIGS. 1A to 2C will be briefly described or omitted.

Referring to FIGS. 3A to 3C, a configuration of the electrode structure 110b of the semiconductor memory device 100b may be different from a configuration of the electrode structure 110 of the semiconductor memory device 100 of FIG. 1A. Specifically, the semiconductor memory device 100b may include a substrate 101, a plurality of electrode structures 110b, a gate stack structure 120b, and a plurality of insulating structures 150. The substrate 101, the gate stack structure 120b, and the insulating structures 150 are the same as described in the substrate 101, the gate stack structure 120, and the insulating structures 150 of the semiconductor memory device 100 of FIG. 1A.

As illustrated in FIG. 3A, the electrode structures 110b may be arranged in a two-dimensional array structure on an x-y plane. Specifically, the electrode structures 110b form a line in the second horizontal direction (y direction), and may be separated from each other by partition wall pillars 130 in the second horizontal direction (y direction). In addition, the electrode structures 110b on two lines adjacent to each other in the first horizontal direction (x direction) may be connected to gate electrodes 122b of the gate stack structures 120b. In addition, the electrode structures 110b constituting the line in the second horizontal direction (y direction) may be arranged in a zigzag shape in the second horizontal direction (y direction) on two lines adjacent to each other in the first horizontal direction (x direction), and may have an offset of 1/2 pitch in the second horizontal direction (y direction).

Each of the electrode structures 110b may include a vertical electrode 112, a first selection electrode layer 114, a switching material layer 116, and a second selection electrode layer 118b. In some embodiments, at least one of the first selection electrode layer 114 and the second selection electrode layer 118b may be omitted.

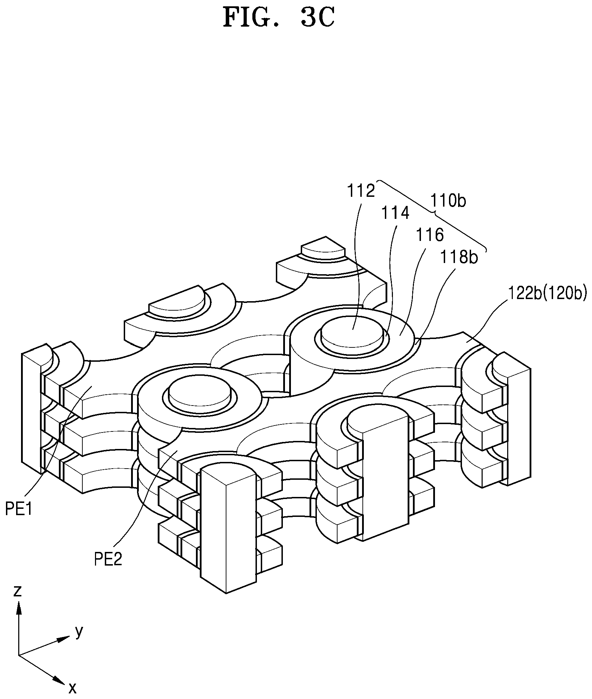

The second selection electrode layer 118b may include a plurality of electrode elements spaced apart from each other for each layer in the vertical direction (z direction). Each of the electrode elements may have two arc shapes facing each other and surrounding a portion of the switching material layer 116. For example, the electrode elements of the second selection electrode layer 118b may be arranged in an arc shape only on the layers where the gate electrode 122b of the gate stack structure 120b is located. Specifically, as can be seen from FIGS. 3A and 3C, each of the electrode elements of the second selection electrode layer 118b may have a circular ring shape surrounding the switching material layer 116 without a portion in contact with both partition wall pillars 130 in the second horizontal direction (y direction). For example, side surfaces of the arc shapes of the electrode elements of the second selection electrode layer 118b may face partition wall pillars 130. Accordingly, the switching material layer 116 may be in contact with the partition wall pillar 130 in the second horizontal direction (y-direction). The electrode elements of the second selection electrode layer 118b may be spaced apart from the electrode elements of other layers in the vertical direction (z direction) and separated from each other.

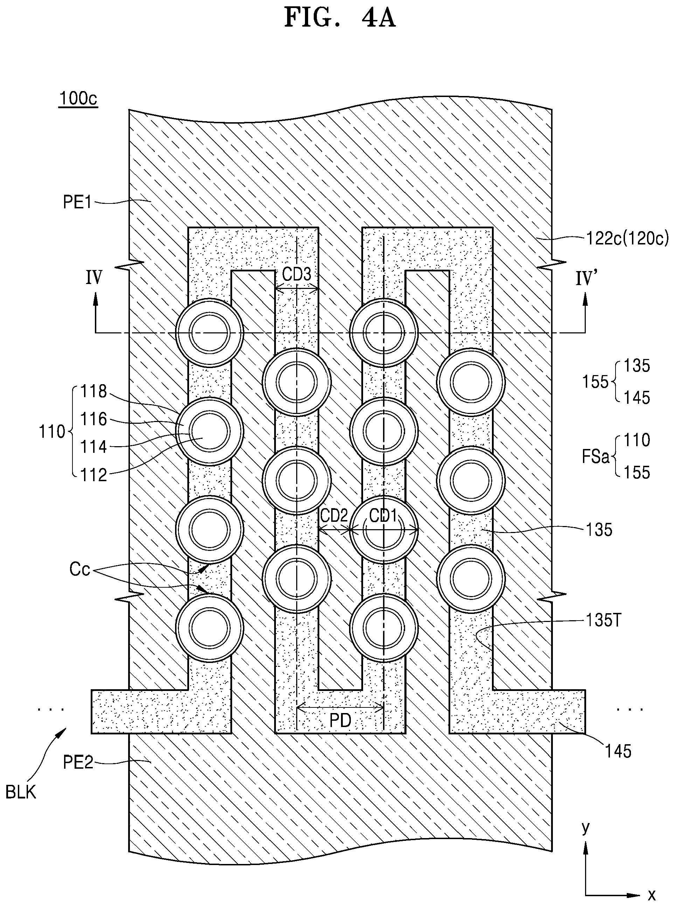

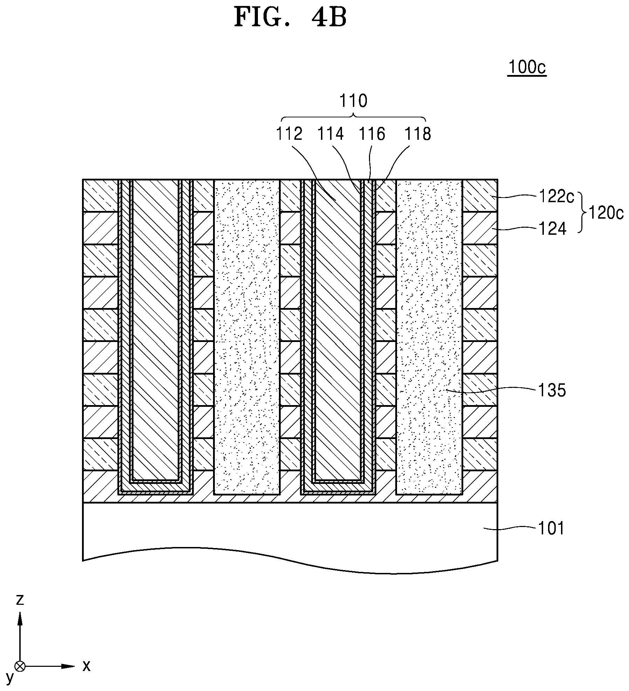

FIGS. 4A to 4C are a plan view, a cross-sectional view, and a perspective view of a semiconductor memory device according to an embodiment. In FIGS. 4A to 4C, redundant description to those described with reference to FIGS. 1A to 3C will be briefly described or omitted.

Referring to FIGS. 4A to 4C, in the semiconductor memory device 100c, the structure of the plurality of insulating structures 155 may be different from the structure of the plurality of insulating structures 150 of the semiconductor memory device 100 of FIG. 1A. Unlike the plurality of insulating structures 150 shown in FIGS. 1A to 3C, the plurality of insulating structures 155 may have a linear shape. The plurality of insulating structures 155 may include a plurality of partition wall pillars 135 and a plurality of trim patterns 145. Specifically, the semiconductor memory device 100c may include a substrate 101, a plurality of electrode structures 110, a gate stack structure 120c, and a plurality of insulating structures 155. The substrate 101, the plurality of electrode structures 110, and the gate stack structure 120c are the same as described in the substrate 101, the plurality of electrode structures 110, and the gate stack structure 120 of the semiconductor memory device 100 of FIG. 1A. However, in the case of the gate stack structure 120c, the width of the gate electrode 122c in the first horizontal direction (x direction) may be wider than that of the gate electrode 122 in the first horizontal direction (x direction) in FIG. 1A at a portion in contact with the partition wall pillar 135.

In one cell block BLK included in the semiconductor memory device 100c, a plurality of electrode structures 110 and a plurality of insulating structures 155 may be alternately arranged along a path with a U-shaped structure that forms a villus shape in a plan view. That is, the plurality of electrode structures 110 and the plurality of insulating structures 155 may form a villus shape of a U-shaped pattern in a plan view. The plurality of electrode structures 110 and the plurality of insulating structures 155 included in one cell block BLK may be alternately arranged to have at least two U-shaped structures forming villus shapes in a plan view, and may be connected to each other to constitute a folding structure FSa. The folding structure FSa may be arranged such that at least two insulating structures 155, which are protrusions of each of villus shapes, faces the second horizontal direction (y direction) or the reverse direction of the second horizontal direction (y direction). Although FIG. 4A illustrates that the folding structure FSa has two U-shaped structures forming villus shapes, the folding structure FSa is not limited thereto. For example, the folding structure FSa may have more than two U-shaped structures forming villus shapes.

Although FIG. 4A illustrates that the plurality of electrode structures 110 are not arranged at the end portions of the protrusions of each of the villus shapes of the folding structure FSa, embodiments are not limited thereto, and the plurality of electrode structures 110 shown in FIG. 4A may be arranged at the end portions of the protrusions of each of the villus shapes of the folding structure FSa as shown in FIG. 1A.

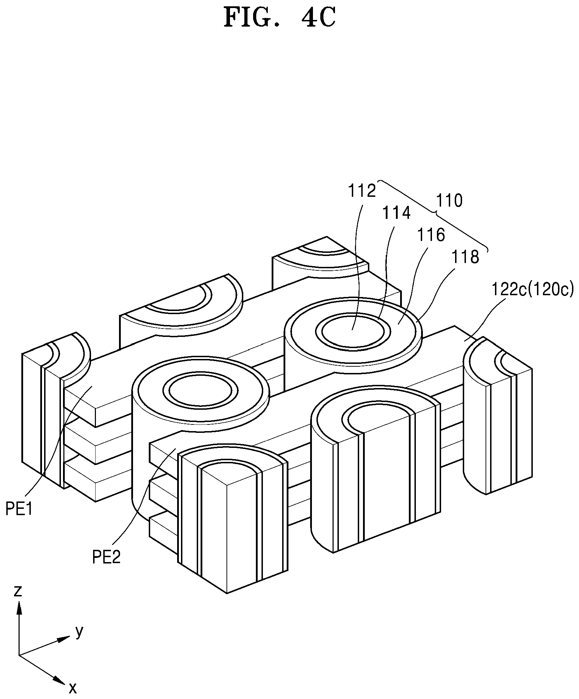

Each of a plurality of partition wall pillars 135 may be arranged between the electrode structures 110 arranged in the second horizontal direction (y-direction). The partition wall pillar 135 has a substantially quadrangular shape, but some of the outer parts may be invaded by electrode structures 110 arranged on both sides in the second horizontal direction (y direction). Accordingly, the partition wall pillars 135 may include concave portions Cc at both sides in the second horizontal direction (y-direction). The partition wall pillar 135 may include an insulating material, for example, silicon oxide, silicon nitride, or silicon oxynitride. In the semiconductor memory device 100c, the partition wall pillars 135 may include silicon oxide. However, the material of the partition wall pillars 135 is not limited to silicon oxide. For reference, the interlayer insulating layers 124 and the partition wall pillars 135 are omitted in FIG. 4C, and empty spaces between the electrode structures 110 in the second horizontal direction (y direction) may correspond to the partition wall pillars 135, and empty spaces between the gate electrodes 122 in the vertical direction (z direction) may correspond to the interlayer insulating layers 124.

A plurality of trim patterns 145 may be arranged on both edge portions of the cell block BLK in the second horizontal direction (y-direction). Here, the cell blocks BLK may be defined by a folding structure FSa composed of the plurality of electrode structures 110 and the plurality of insulating structures 155 alternately arranged and connected to each other to have at least two U-shaped structures formed of villus-shapes in a plan view. In this regard, one cell block BLK may include one folding structure FSa. For example, each of the folding structures FSa spaced apart from each other in a plan view may constitute a separate cell block BLK. Some of the trim patterns 145 may have a U shape in a plan view. In some embodiments, when the plurality of electrode structures 110 are arranged in the same manner as the plurality of electrode structures 110 shown in FIG. 1A , the trim patterns 145 may each have an "L" shape similar to the trim patterns 140 shown in FIG. 1A. In this regard, the trim patterns 145 may each include a portion that extends in the first horizontal direction (x direction) and a portion that extends in the second horizontal direction (y direction).

In addition, the trim patterns 145 may each have a width covering the two adjacent partition wall pillars 135 in the first horizontal direction (x direction). That is, among the lines in which the electrode structures 110 are arranged in the second horizontal direction (y direction), two lines adjacent in the first horizontal direction (x direction) may be in contact with trim patterns 145 arranged below or above in the second horizontal direction (y direction) through the electrode structures 110. The trim patterns 145 below in the second horizontal direction (y direction) and the trim patterns 145 above in the second horizontal direction (y direction) may be arranged at alternating positions along the second horizontal direction (y direction). In addition, two trim patterns 145 facing each other in the second horizontal direction (y direction) and adjacent to each other in the first horizontal direction (x direction) may cover one line in which electrode structures 110 are arranged together in the second horizontal direction (y direction), and may be arranged in a point-symmetric structure based on any one part on the line, for example, the electrode structure 110 of the central part on the line.

The trim patterns 145 may include an insulating material, for example, silicon oxide, silicon nitride, or silicon oxynitride. In the semiconductor memory device 100c, the plurality of trim patterns 145 may be formed together with the plurality of partition wall pillars 135, and the plurality of partition wall pillars 135 and the plurality of trim patterns 145 may be referred to as the plurality of insulating structures 155. For example, the trim patterns 145 may include silicon oxide. However, the materials of the trim patterns 145 are not limited to silicon oxide.

The electrode structure 110 may have a diameter of CD1, the electrode structure 110 and the partition wall pillar 135 may have an interval of CD2 in the first horizontal direction (x-direction), and a plurality of insulating structures 155 having a line shape may have a horizontal width of CD3. For example, when a pitch PD between the electrode structure 110 and the partition wall pillar 135 in the first horizontal direction (x direction) is about 160 nm, CD1 may be about 120 nm, CD2 may be about 60 nm, and CD3 may be about 80 nm.

Although FIGS. 4A to 4C show that the semiconductor memory device 100c includes the plurality of electrode structures 110, embodiments are not limited thereto, and instead of the plurality of electrode structures 110, the semiconductor memory device 100c may include the plurality of electrode structures 110a shown in FIGS. 2A to 2C or the plurality of electrode structures 110b shown in FIGS. 3A to 3C.

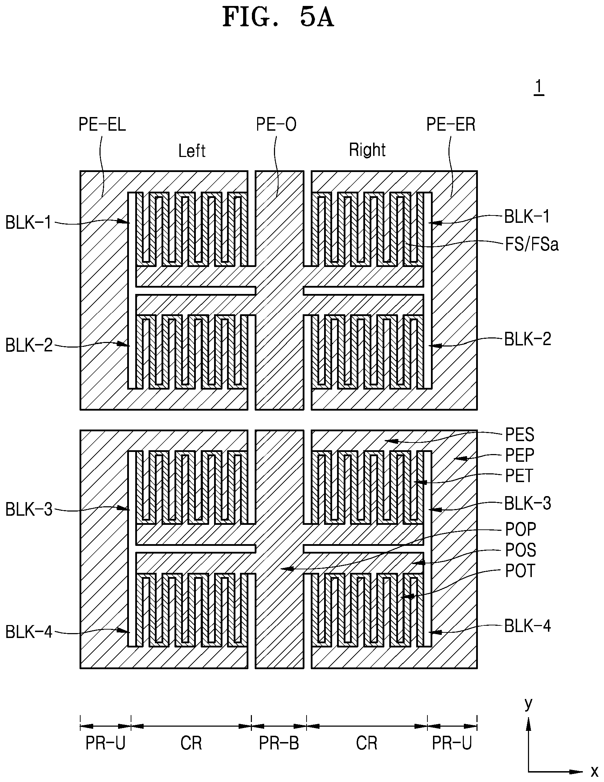

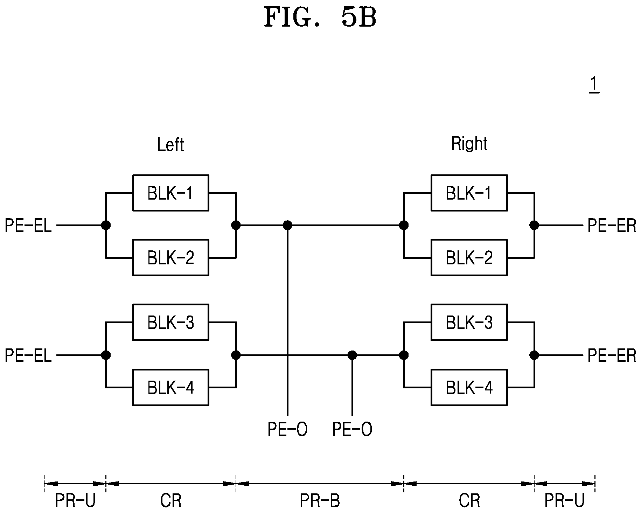

FIGS. 5A and 5B are a plan view and a block diagram of a semiconductor memory device according to an embodiment.

Referring to FIGS. 5A and 5B, a semiconductor memory device 1 has a plurality of cell regions CR and a plurality of pad regions PR-U and PR-B. The plurality of pad regions PR-U and PR-B and the plurality of cell regions CR may be alternately arranged in the first horizontal direction (x direction). The semiconductor memory device 1 includes a plurality of cell blocks BLK-1, BLK-2, BLK-3, and BLK-4 arranged in the cell regions CR. The semiconductor memory device 1 may include block groups arranged in the first horizontal direction (x-direction). Each of the block groups may include a first cell block BLK-1, a second cell block BLK-2, a third cell block BLK-3, and a fourth cell block BLK-4 sequentially arranged in the second horizontal direction (y-direction). One cell block included in each of the block groups may be arranged in the first horizontal direction (x direction), and a plurality of cell blocks may be arranged in the second horizontal direction (y direction). For example, the block groups may include a first block group (Left) arranged on the left and a second block group (Right) arranged on the right.

The first cell block BLK-1, the second cell block BLK-2, the third cell block BLK-3, and the fourth cell block BLK-4 sequentially arranged in the second horizontal direction (y-direction) in the first block group Left arranged on the left side may be referred to as a first left cell block, a second left cell block, a third left cell block, and a fourth left cell block, and the first cell block BLK-1, the second cell block BLK-2, the third cell block BLK-3, and the fourth cell block BLK-4 sequentially arranged in the second horizontal direction (y-direction) in the second block group Right arranged on the right side may be referred to as a first right cell block, a second right cell block, a third right cell block, and a fourth right cell block. The first left cell block, the second left cell block, the third left cell block, and the fourth left cell block, may be arranged in the first horizontal direction (x direction), respectively, with the first right cell block, the second right cell block, the third right cell block, and the fourth right cell block.

Each of the plurality of cell blocks BLK-1, BLK-2, BLK-3, and BLK-4 may include a folding structure FS/FSa. The folding structure FS/FSa may be the folding structure FS shown in FIGS. 1A to 3C or the folding structure FSa shown in FIGS. 4A to 4C.

The folding structure FS/FSa included in the first cell block BLK-1 and the folding structure FS/FSa included in the second cell block BLK-2 may be symmetrically arranged based on a straight line extending in the first horizontal direction (x direction) between the first cell block BLK-1 and the second cell block BLK-2. Likewise, the folding structure FS/FSa included in the third cell block BLK-3 and the folding structure FS/FSa included in the fourth cell block BLK-4 may be symmetrically arranged based on a straight line extending in the first horizontal direction (x direction) between the third cell block BLK-3 and the fourth cell block BLK-4. The folding structure FS/FSa included in the first cell block BLK-1, the second cell block BLK-2, the third cell block BLK-3, and the fourth cell block BLK-4 included in the first block group Left, that is, the first left cell block, the second left cell block, the third left cell block, and the fourth left cell block, and the folding structure FS/FSa included in the first cell block BLK-1, the second cell block BLK-2, the third cell block BLK-3, and the fourth cell block BLK-4 included in the second block group Right, that is, the first right cell block, the second right cell block, the third right cell block, and the fourth right cell block, may be symmetrically arranged based on a straight line extending in the second horizontal direction (y direction) between the first block group Left and the second block group Right.

The semiconductor memory device 1 may include three plate electrodes corresponding to four cell blocks for each layer in a vertical direction. For example, three plate electrodes for each layer in the vertical direction may correspond to the first left cell block, the second left cell block, the first right cell block, and the second right cell block. Alternatively, for example, three plate electrodes for each layer in the vertical direction may correspond to the third left cell block, the fourth left cell block, the third right cell block, and the fourth right cell block. The plate electrode may include a pad part, a shaft part, and a sawtooth part. The three plate electrodes corresponding to the four cell blocks may include one odd plate electrode PE-O and two even plate electrodes PE-EL and PE-ER. The two even plate electrodes PE-EL and PE-ER may include a first even plate electrode PE-EL arranged on the left side and a second even plate electrode PE-ER arranged on the right side. Hereinafter, although described based on the first left cell block, the second left cell block, the first right cell block, and the second right cell block, the same manner may be also applied to the third left cell block, the fourth left cell block, the third right cell block, and the fourth right cell block.

An odd plate electrode PE-O may include an odd pad part POP, an odd shaft part POS extending from the odd pad part POP, and a plurality of odd sawtooth part POT extending from the odd shaft part POS. Each of the first and second even plate electrodes PE-EL and PE-ER may include an even pad part PEP, an even shaft part PES extending from the even pad part PEP, and a plurality of even sawtooth parts PET extending from the even shaft part PES. The odd pad part POP and the even pad part PEP may extend in the second horizontal direction (y direction), the odd shaft part POS and the even shaft part PES may extend in the first horizontal direction (x direction), and the odd sawtooth part POT and the even sawtooth part PET may extend in the second horizontal direction (y direction).

The even pad part PEP, the even shaft part PES, and the even sawtooth part PET of the first even plate electrode PE-EL may be referred to as a first even pad part, a first even shaft part, and a first even sawtooth part, and the even pad part PEP, the even shaft part PES, and the even sawtooth part PET of the second even plate electrode PE-ER may be referred to as a second even pad part, a second even shaft part, and a second even sawtooth part. The odd pad part POP, the odd shaft part POS, and the odd sawtooth part POT of the odd plate electrode PE-O may be integrally connected, and the even pad part PEP, the even shaft part PES, and the even sawtooth part PET of each of the first even plate electrode PE-EL and the second even plate electrode PE-ER may be integrally connected.

The plurality of cell regions CR and the plurality of pad regions PR-U and PR-B may be alternately arranged in the first horizontal direction (x direction). The plurality of pad regions PR-U and PR-B may include first pad regions PR-U and second pad regions PR-B. The second pad region PR-B may be positioned between an even of adjacent cell regions CR in the first horizontal direction (x direction), and the first pad regions PR-U may be positioned at both ends of the plurality of cell regions CR in the first horizontal direction (x direction).

The first even shaft part and the plurality of first even sawtooth parts of the first even plate electrode PE-EL may be the first plate electrodes PE1 of FIGS. 1A, 1C, 2A, 2C, 3A, and 3C of the first left cell block and the second left cell block, and the odd axis part POS and the plurality of odd sawtooth parts POT of the odd plate electrode PE-O may be the second plate electrodes PE2 of FIGS. 1A, 1C, 2A, 2C, 3A, and 3C of the first left cell block and the second left cell block. The odd shaft part POS and the plurality of odd sawtooth parts POT of the odd plate electrode PE-O may be the first plate electrode PE1 of the first right cell block and the second right cell block, and The second even shaft part and the plurality of second even sawtooth parts of the second even plate electrode PE-ER may be the second plate electrodes PE2 of the first right cell block and the second right cell block. That is, the odd axis part POS and the plurality of odd sawtooth parts POT of the odd plate electrode PE-O may be the second plate electrodes PE2 of the first left cell block and the second left cell block and the first plate electrodes PE1 of the first right cell block and the second right cell block.

Each of the first even pad part of the first even plate electrode PE-EL and the second even pad part of the second even plate electrode PE-ER may be arranged in the first pad region PR-U, and the odd pad part POP of the odd plate electrode PE-O may be arranged in the second pad region PR-B.

The first even pad part of the first even plate electrode PE-EL is shared by the first left cell block and the second left cell block when the pad is connected to the first plate electrode PE1 of the first left cell block and the second left cell block. The odd pad part POP of the odd plate electrode PE-O is shared by the first left cell block, the second left cell block, the first right cell block, and the second right cell block when the pad is connected to the second plate electrode PE2 of the first left cell block and the second left cell block, and the first plate electrodes PE1 of the first right cell block and the second right cell block. The second even pad part of the second even plate electrode PE-ER may be shared by the first right cell block and the second right cell block to correspond to the pad connected to the second plate electrode PE2 of the first right cell block and the second right cell block.

Each of the first even pad part of the first even plate electrode PE-EL and the second even pad part of the second even plate electrode PE-ER may be connected to one of the cell blocks arranged in the first horizontal direction (x direction), and may be connected to two of the cell blocks arranged in the second horizontal direction (y direction), respectively to be connected to two cell blocks. The odd pad part POP of the odd plate electrode PE-O may be connected to two rows of the cell blocks arranged in the first horizontal direction (x direction), and may be connected to two columns of the cell blocks arranged in the second horizontal direction (y direction) to be connected to four cell blocks.

As the number of memory cells stack in the vertical direction increases, an area where the pads in the form of steps for connecting to the memory cells increases. However, in the semiconductor memory device 1 according to embodiments, three pads may correspond to four cell blocks for each layer in the vertical direction, so that an area occupied by step-shaped pads in the semiconductor memory device 1 is reduced, thereby improving the degree of integration of the semiconductor memory device 1.

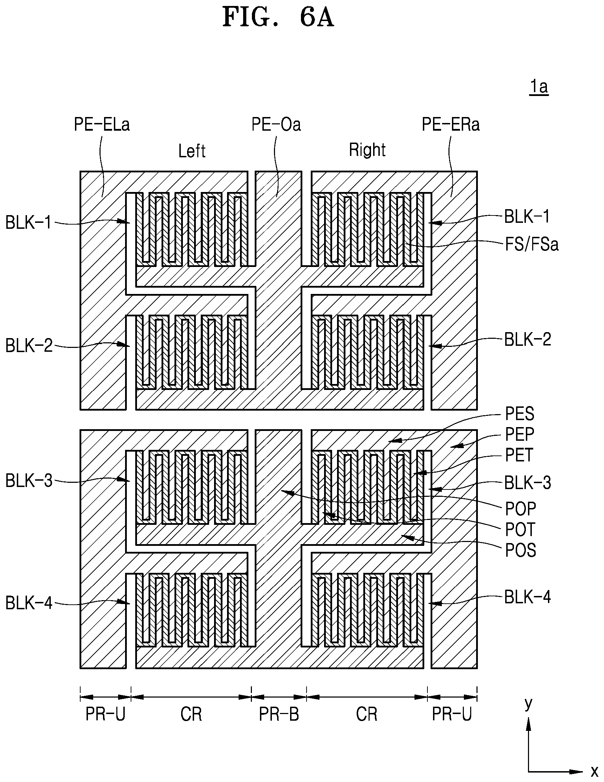

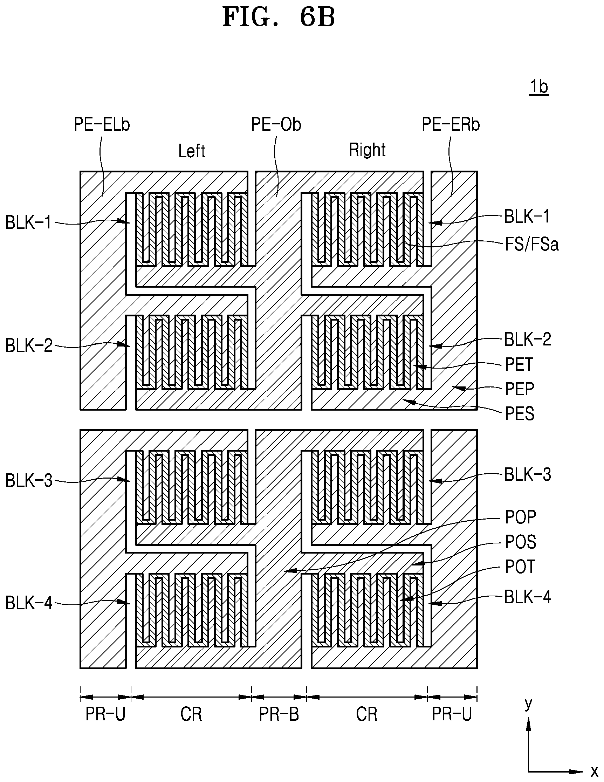

FIGS. 6A and 6B are plan views of a semiconductor memory device according to an embodiment. In FIGS. 6A and 6B, redundant description to those described with reference to FIGS. 5A and 5B will be briefly described or omitted.

Referring to FIG. 6A, a semiconductor memory device 1a has a plurality of cell regions CR and a plurality of pad regions PR-U and PR-B. The semiconductor memory device 1a includes a plurality of cell blocks BLK-1, BLK-2, BLK-3, and BLK-4 arranged in the cell regions CR. The semiconductor memory device 1a may include block groups arranged in the first horizontal direction (x-direction). Each of the plurality of cell blocks BLK-1, BLK-2, BLK-3, and BLK-4 may include a folding structure FS/FSa.

The folding structure FS/FSa, which is included in each of the first left cell block, the second left cell block, the third left cell block, and the fourth left cell block, has the same structure and may be arranged in the second horizontal direction (y-direction), and the folding structure FS/FSa included in each of the first right cell block, the second right cell block, the third right cell block, and the fourth right cell block has the same structure and may be arranged in the second horizontal direction (y-direction). The folding structure FS/FSa included in each of the first left cell block, the second left cell block, the third left cell block, and the fourth left cell block, and the folding structure FS/FSa included in each of the first right cell block, the second right cell block, the third right cell block, and the fourth right cell block may be symmetrically arranged with respect to a straight line extending in the second horizontal direction (y-direction) between the first block group Left and the second block group Right.

The semiconductor memory device 1a may include an odd plate electrode PE-Oa, a first even plate electrode PE-ELa, and a second even plate electrode PE-ERa. The odd plate electrode PE-Oa, the first even plate electrode PE-ELa, and the second even plate electrode PE-ERa are generally the same as the odd plate electrode PE-O, the first even plate electrode PE-EL, and the second even plate electrode PE-ER shown in FIG. 5A. However, the arrangement of the even shaft part PES and the even sawtooth part PET connected thereto, and/or the arrangement of the odd shaft part POS and the odd sawtooth part POT connected thereto may vary according to the arrangement of the folding structure FS/FSa included in each of the plurality of cell blocks BLK-1, BLK-2, BLK-3, and BLK-4. For example, the two even shaft parts PES included in the first even plate electrode PE-EL or the second even plate electrode PE-ER shown in FIG. 5A extend to the upper side of one of the corresponding two folding structures FS/FSa and to the lower side of the other folding structure FS/FSa. However, each of the two even shafts PES included in the first even plate electrode PE-ELa or the second even plate electrode PE-ERa shown in FIG. 6A extends to the upper side of each of the corresponding two folding structures FS/FSa. Likewise, the two odd shaft parts POS included in the odd plate electrode PE-O shown in FIG. 5A extend to the upper side of one of the corresponding two folding structures FS/FSa and to the lower side of the other folding structure FS/FSa. However, each of the four odd shaft parts POS included in the odd plate electrode PE-Oa shown in FIG. 6A extends to the lower side of each of the corresponding two folding structures FS/FSa.

Referring to FIG. 6B, a semiconductor memory device 1b has a plurality of cell regions CR and a plurality of pad regions PR-U and PR-B. The semiconductor memory device 1b includes a plurality of cell blocks BLK-1, BLK-2, BLK-3, and BLK-4 arranged in the cell regions CR. The semiconductor memory device 1b may include block groups arranged in the first horizontal direction (x-direction). Each of the plurality of cell blocks BLK-1, BLK-2, BLK-3, and BLK-4 may include a folding structure FS/FSa. The folding structures FS/FSa included in the plurality of cell blocks BLK-1, BLK-2, BLK-3, and BLK-4, i.e., the first left cell block, the second left cell block, the third left cell block, the fourth left cell block, the first right cell block, the second right cell block, the third right cell block, and the fourth right cell block may be arranged with the same structure.

The semiconductor memory device 1b may include an odd plate electrode PE-Ob, a first even plate electrode PE-ELb, and a second even plate electrode PE-ERb. The odd plate electrode PE-Ob, the first even plate electrode PE-ELb, and the second even plate electrode PE-ERb are generally the same as the odd plate electrode PE-O, the first even plate electrode PE-EL, and the second even plate electrode PE-ER shown in FIG. 5A. However, the arrangement of the even shaft part PES and the even sawtooth part PET connected thereto, and/or the arrangement of the odd shaft part POS and the odd sawtooth part POT connected thereto may vary according to the arrangement of the folding structure FS/FSa included in each of the plurality of cell blocks BLK-1, BLK-2, BLK-3, and BLK-4. For example, each of the two even shaft parts PES included in the first even plate electrode PE-ELb shown in FIG. 6B extends to the upper side of each of the corresponding two folding structures FS/FSa, and each of the two even shaft parts PES included in the second even plate electrode PE-ERb extends to the lower side of each of the corresponding two folding structures FS/FSa. Among the four odd shaft parts POS included in the odd plate electrode PE-Ob, each of the two odd shaft parts POS corresponding to the folding structures FS/FSa arranged in the first block group Left extends to the lower side of each of the corresponding folding structures FS/FSa, and each of the two odd shaft parts POS corresponding to the folding structures FS/FSa arranged in the second block group Right extends to the upper side of each of the corresponding folding structures FS/FSa.

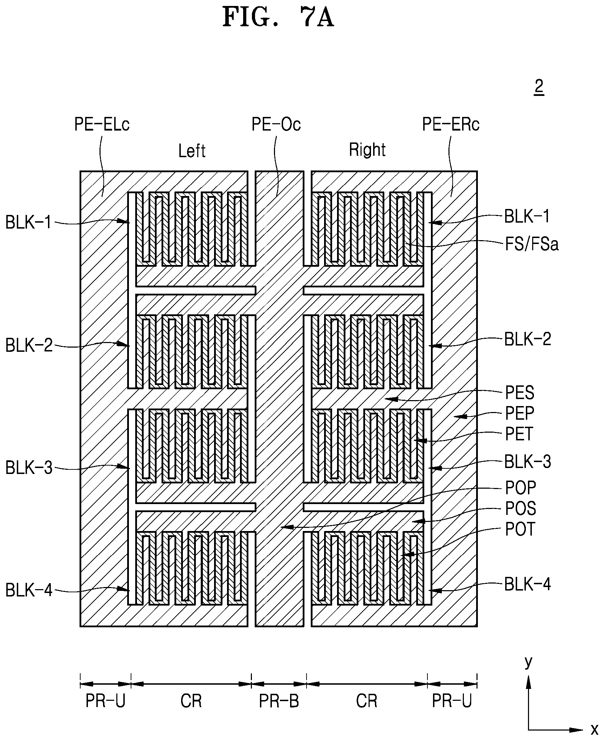

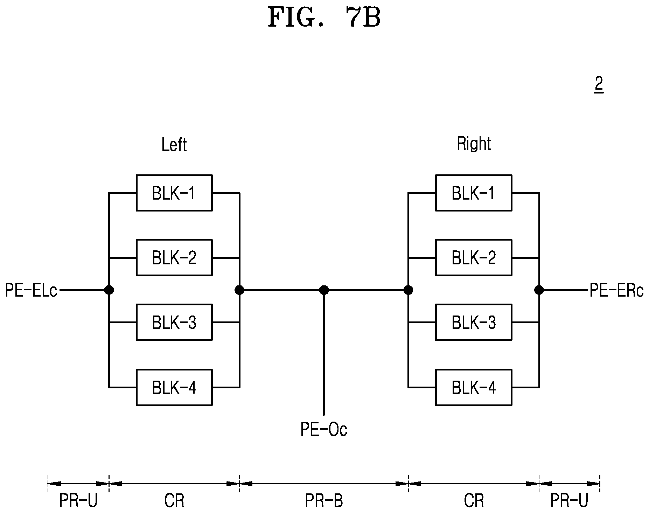

FIGS. 7A and 7B are a plan view and a block diagram of a semiconductor memory device according to an embodiment. In FIGS. 7A and 7B, redundant description to those described with reference to FIGS. 5A to 6B will be briefly described or omitted.

Referring to FIGS. 7A and 7B, a semiconductor memory device 2 has a plurality of cell regions CR and a plurality of pad regions PR-U and PR-B. The semiconductor memory device 2 includes a plurality of cell blocks BLK-1, BLK-2, BLK-3, and BLK-4 arranged in the cell regions CR. The semiconductor memory device 2 may include block groups arranged in the first horizontal direction (x-direction). Each of the plurality of cell blocks BLK-1, BLK-2, BLK-3, and BLK-4 may include a folding structure FS/FSa.

The semiconductor memory device 2 may include an odd plate electrode PE-Oc, a first even plate electrode PE-ELc, and a second even plate electrode PE-ERc. The odd plate electrode PE-Oc, the first even plate electrode PE-ELc, and the second even plate electrode PE-ERc are generally the same as the odd plate electrode PE-O, the first even plate electrode PE-EL, and the second even plate electrode PE-ER shown in FIG. 5A, but the number of cell blocks to which the odd plate electrode PE-Oc, the first even plate electrode PE-ELc, and the second even plate electrode PE-ERc are connected may vary. Each of the first even pad part of the first even plate electrode PE-ELc and the second even pad part of the second even plate electrode PE-ERc may be connected to one column of the cell blocks arranged in the second horizontal direction (y direction), and may be connected to four rows of cell blocks arranged in the first horizontal direction (x direction), respectively, to be connected to four cell blocks. The odd pad part POP of the odd plate electrode PE-Oc may be connected to two of the cell blocks arranged in a row extending in the first horizontal direction (x direction), and may be connected to four of the cell blocks arranged in a column extending in the second horizontal direction (y direction) to be connected to eight cell blocks.

In the semiconductor memory device 2, three pads may correspond to eight cell blocks for each layer in the vertical direction, so that an area occupied by step-shaped pads in the semiconductor memory device 2 is reduced, thereby improving the degree of integration of the semiconductor memory device 2.

In the semiconductor memory device 1 shown in FIGS. 5A and 5B, it is illustrated that three pads correspond to four cell blocks for each layer in the vertical direction, and in the semiconductor memory device 2 shown in FIGS. 7A and 7B, it is illustrated that three pads correspond to eight cell blocks for each layer in the vertical direction, but embodiments are not limited thereto. For example, in the semiconductor memory device according to embodiments, three pads may correspond to six cell blocks or 10 or more, that is, even-numbered cell blocks for each layer in a vertical direction. That is, in the semiconductor memory device according to embodiments, three pads may correspond to 2*k cell blocks (k is an integer of 2 or more) for each layer in the vertical direction.

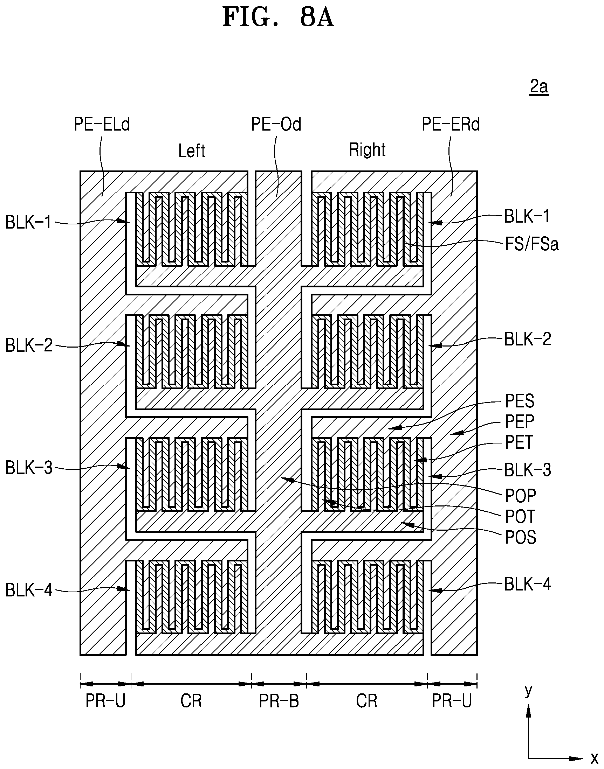

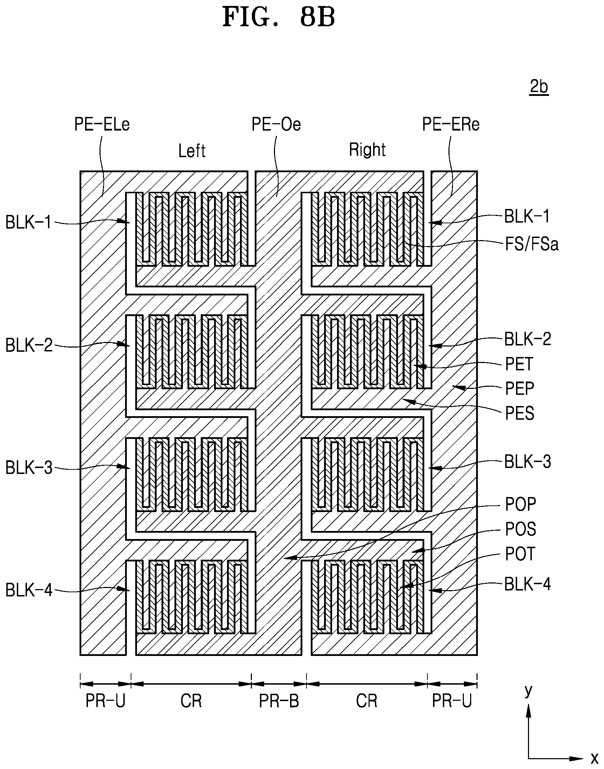

FIGS. 8A and 8B are plan views of a semiconductor memory device according to an embodiment. In FIGS. 8A and 8B, redundant description to those described with reference to FIGS. 5A to 7B will be briefly described or omitted.

Referring to FIG. 8A, a semiconductor memory device 2a has a plurality of cell regions CR and a plurality of pad regions PR-U and PR-B. The semiconductor memory device 2a includes a plurality of cell blocks BLK-1, BLK-2, BLK-3, and BLK-4 arranged in the cell regions CR. The semiconductor memory device 2a may include block groups arranged in the first horizontal direction (x-direction). Each of the plurality of cell blocks BLK-1, BLK-2, BLK-3, and BLK-4 may include a folding structure FS/FSa.

The folding structure FS/FSa, which is included in each of the first left cell block, the second left cell block, the third left cell block, and the fourth left cell block, has the same structure and may be arranged in the second horizontal direction (y-direction), and the folding structure FS/FSa included in each of the first right cell block, the second right cell block, the third right cell block, and the fourth right cell block has the same structure and may be arranged in the second horizontal direction (y-direction). The folding structure FS/FSa included in each of the first left cell block, the second left cell block, the third left cell block, and the fourth left cell block, and the folding structure FS/FSa included in each of the first right cell block, the second right cell block, the third right cell block, and the fourth right cell block may be symmetrically arranged with respect to a straight line extending in the second horizontal direction (y-direction) between the first block group Left and the second block group Right.

The semiconductor memory device 2a may include an odd plate electrode PE-Od, a first even plate electrode PE-ELd, and a second even plate electrode PE-ERd. The odd plate electrode PE-Od, the first even plate electrode PE-ELd, and the second even plate electrode PE-ERd are generally the same as the odd plate electrode PE-Oc, the first even plate electrode PE-ELc, and the second even plate electrode PE-ERc shown in FIG. 7A. However, the arrangement of the even shaft part PES and the even sawtooth part PET connected thereto, and/or the arrangement of the odd shaft part POS and the odd sawtooth part POT connected thereto may vary according to the arrangement of the folding structure FS/FSa included in each of the plurality of cell blocks BLK-1, BLK-2, BLK-3, and BLK-4. For example, each of the two even shaft parts PES included in the first even plate electrode PE-ELd extends to the upper side of each of the corresponding folding structures FS/FSa, and each of the even shaft parts PES included in the second even plate electrode PE-ERd extends to the upper side of each of the corresponding folding structures FS/FSa. Each of the odd shaft parts POS included in the odd plate electrode PE-Od extends to the lower side of each of the corresponding folding structures FS/FSa.

Referring to FIG. 8B, a semiconductor memory device 2b has a plurality of cell regions CR and a plurality of pad regions PR-U and PR-B. The semiconductor memory device 2b includes a plurality of cell blocks BLK-1, BLK-2, BLK-3, and BLK-4 arranged in the cell regions CR. The semiconductor memory device 2b may include block groups arranged in the first horizontal direction (x-direction). Each of the plurality of cell blocks BLK-1, BLK-2, BLK-3, and BLK-4 may include a folding structure FS/FSa. The folding structures FS/FSa included in the plurality of cell blocks BLK-1, BLK-2, BLK-3, and BLK-4, i.e., the first left cell block, the second left cell block, the third left cell block, the fourth left cell block, the first right cell block, the second right cell block, the third right cell block, and the fourth right cell block may be arranged with the same structure.

The semiconductor memory device 2b may include an odd plate electrode PE-Oe, a first even plate electrode PE-ELe, and a second even plate electrode PE-ERe. The odd plate electrode PE-Oe, the first even plate electrode PE-ELe, and the second even plate electrode PE-ERe are generally the same as the odd plate electrode PE-Oc, the first even plate electrode PE-ELc, and the second even plate electrode PE-ERc shown in FIG. 7A. However, the arrangement of the even shaft part PES and the even sawtooth part PET, and/or the arrangement of the odd shaft part POS and the odd sawtooth part POT may vary according to the arrangement of the folding structure FS/FSa included in each of the plurality of cell blocks BLK-1, BLK-2, BLK-3, and BLK-4. For example, each of the even shaft parts PES included in the first even plate electrode PE-ELe shown in FIG. 8B extends to the upper side of each of the corresponding folding structures FS/FSa, and each of the even shaft parts PES included in the second even plate electrode PE-ERe extends to the lower side of each of the corresponding folding structures FS/FSa. Among the eight odd shaft parts POS included in the odd plate electrode PE-Oe, each of the odd shaft parts POS corresponding to the folding structures FS/FSa arranged in the first block group Left extends to the lower side of each of the corresponding folding structures FS/FSa, and each of the odd shaft parts POS corresponding to the folding structures FS/FSa arranged in the second block group Right extends to the upper side of each of the corresponding folding structures FS/FSa.

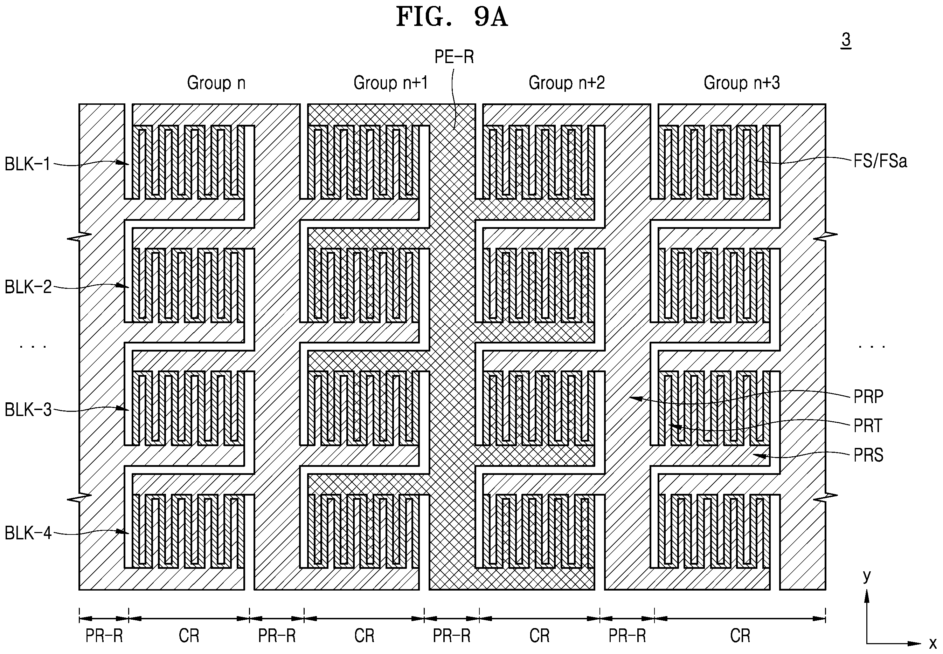

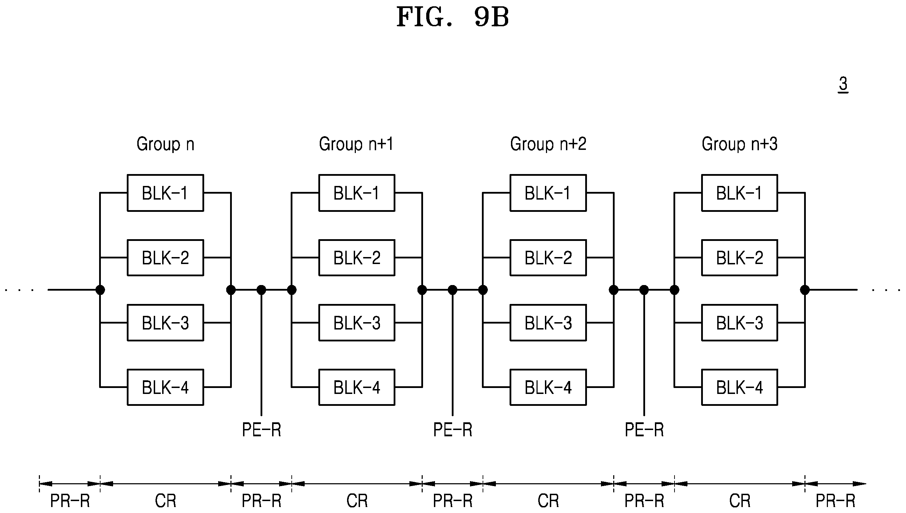

FIGS. 9A and 9B are a plan view and a block diagram of a semiconductor memory device according to an embodiment. In FIGS. 9A and 9B, redundant description to those described with reference to FIGS. 5A to 8B will be briefly described or omitted.

Referring to FIGS. 9A and 9B, a semiconductor memory device 3 has a plurality of cell regions CR and a plurality of pad regions PR-R. The semiconductor memory device 3 includes a plurality of cell blocks BLK-1, BLK-2, BLK-3, and BLK-4 arranged in the cell regions CR. The semiconductor memory device 3 may include a plurality of block groups Group n, Group n+1, Group n+2, and Group n+3 arranged in the first horizontal direction (x-direction) (n is an integer of 1 or more). Each of a plurality of block groups Group n, Group n+1, Group n+2, and Group n+3 may include a first cell block BLK-1, a second cell block BLK-2, a third cell block BLK-3, and a fourth cell block BLK-4 sequentially arranged in the second horizontal direction (y-direction). Each of the plurality of cell blocks BLK-1, BLK-2, BLK-3, and BLK-4 may include a folding structure FS/FSa.

A plurality of repeating plate electrodes PE-R may be arranged between two adjacent block groups in the first horizontal direction (x direction) among the plurality of block groups Group n, Group n+1, Group n+2, and Group n+3. Each of the plurality of repeating plate electrodes PE-R has the same shape, and may be repeatedly arranged between two adjacent block groups in the first horizontal direction (x direction) of the plurality of block groups Group n, Group n+1, Group n+2, and Group n+3.

The folding structure FS/FSa included in each of the cell blocks arranged in the first horizontal direction (x direction) may be arranged with the same structure. For example, the folding structure FS/FSa included in each of the first cell blocks BLK-1 included in the plurality of block groups Group n, Group n+1, Group n+2, and Group n+3 may be arranged with the same structure, the folding structure FS/FSa included in each of the second cell blocks BLK-2 may be arranged with the same structure, the folding structure FS/FSa included in each of the third cell blocks BLK-3 may be arranged with the same structure, and the folding structure FS/FSa included in each of the fourth cell blocks BLK-4 may be arranged with the same structure. The folding structure FS/FSa included in the first cell block BLK-1 and the folding structure FS/FSa included in the second cell block BLK-2 may be symmetrically arranged based on a straight line extending in the first horizontal direction (x direction) between the first cell block BLK-1 and the second cell block BLK-2, The folding structure FS/FSa included in the second cell block BLK-2 and the folding structure FS/FSa included in the third cell block BLK-3 may be symmetrically arranged based on a straight line extending in the first horizontal direction (x direction) between the second cell block BLK-2 and the third cell block BLK-3, and the folding structure FS/FSa included in the third cell block BLK-3 and the folding structure FS/FSa included in the fourth cell block BLK-4 may be symmetrically arranged based on a straight line extending in the first horizontal direction (x direction) between the third cell block BLK-3 and the fourth cell block BLK-4.

The repeating plate electrode PE-R may include a repeating pad part PRP, a repeating shaft part PRS extending from the repeating pad part PRP, and a plurality of repeating sawtooth part PRT extending from the repeating shaft part PRS. The repeating pad parts PRP may be arranged in the pad regions PR-R. The repeating pad part PRP may extend in the second horizontal direction (y-direction), the repeating shaft part PRS may extend in the first horizontal direction (x-direction), and the repeating sawtooth part PRT may extend in the second horizontal direction (y-direction). The repeating plate electrode PE-R is generally the same as the odd plate electrodes PE-Oc, PE-Od, and PE-Oe including the odd pad part POP, the odd shaft part POS, and the odd sawtooth part POT shown in FIGS. 7A, 8A, and 8B. However, in response to the arrangement of the folding structure FS/FSa included in each of the plurality of cell blocks BLK-1, BLK-2, BLK-3, and BLK-4, the arrangement of the repeating shaft part PRS and the repeating sawtooth part PRT connected thereto, may vary. For example, the repeating shaft parts PRS extending to the left in the first horizontal direction (x direction) from the repeating pad parts PRP included in one repeating plate electrode PE-R extend to the upper side of the corresponding folding structure FS/FSa, and the repeating shaft parts PRS extending to the right in the first horizontal direction (x direction) from the repeating pad parts PRP included in one repeating plate electrode PE-R extend to the lower side of the corresponding folding structure FS/FSa.

In some embodiments, even plate electrodes which are the same or similar to the first even plate electrodes PE-ELc, PE-ELd, and PE-ELe and the second even plate electrodes PE-ERc, PE-ERd, and PE-ERe as described with reference to FIGS. 7A to 8B, may be connected to block groups arranged at opposite ends in the first horizontal direction (x direction) among the plurality of block groups Group n, Group n+1, Group n+2, and Group n+3.

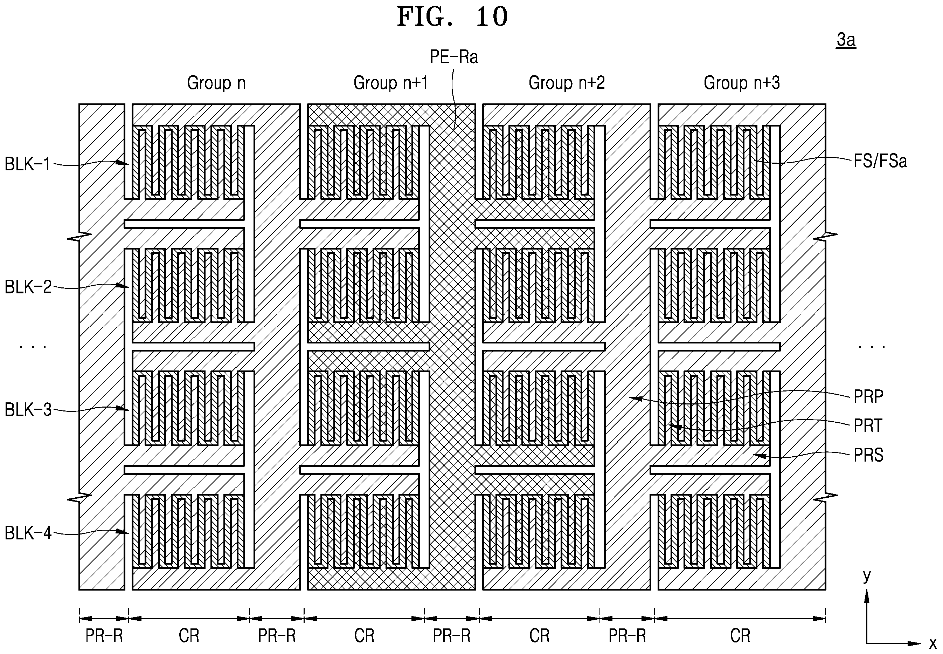

FIG. 10 is a plan view of a semiconductor memory device according to an embodiment. In FIG. 10, redundant description to those described with reference to FIGS. 5A to 9B will be briefly described or omitted.

Referring to FIG.10, a semiconductor memory device 3a has a plurality of cell regions CR and a plurality of pad regions PR-R. The semiconductor memory device 3a includes a plurality of cell blocks BLK-1, BLK-2, BLK-3, and BLK-4 arranged in the cell regions CR. The semiconductor memory device 3a may include a plurality of block groups Group n, Group n+1, Group n+2, and Group n+3 arranged in the first horizontal direction (x-direction) (n is an integer of 1 or more). Each of a plurality of block groups Group n, Group n+1, Group n+2, and Group n+3 may include a first cell block BLK-1, a second cell block BLK-2, a third cell block BLK-3, and a fourth cell block BLK-4 sequentially arranged in the second horizontal direction (y-direction). Each of the plurality of cell blocks BLK-1, BLK-2, BLK-3, and BLK-4 may include a folding structure FS/FSa.

A plurality of repeating plate electrodes PE-Ra may be arranged between two adjacent block groups in the first horizontal direction (x direction) among the plurality of block groups Group n, Group n+1, Group n+2, and Group n+3. Each of the plurality of repeating plate electrodes PE-Ra has the same shape, and may be repeatedly arranged between two adjacent block groups in the first horizontal direction (x direction) of the plurality of block groups Group n, Group n+1, Group n+2, and Group n+3. The repeating plate electrode PE-Ra is substantially the same as the repeating plate electrode PE-R shown in FIG. 9A, but the arrangement of the repeating shaft parts PRS may vary. For example, the repeating shaft parts PRS included in the repeating plate electrode PE-Ra may be arranged in the second horizontal direction (y direction) and may alternately extend to the upper and lower sides of the corresponding folding structures FS/FSa.

While the inventive concept has been particularly shown and described with reference to embodiments thereof, it will be understood that various changes in form and details may be made therein without departing from the scope of the following claims.

## Claims

1. A semiconductor memory device comprising:
a plurality of cell blocks (BLK), each comprising a folding structure (FS) in which a plurality of electrode structures (110) and a plurality of insulating structures (150) are alternately provided, wherein each of the plurality of electrode structures (110) and each of the plurality of insulating structures (150) extend in a vertical direction (z) and are connected with each other so as to have at least two U-shaped structures in a plan view, the plurality of electrode structures (110) comprise a vertical electrode (112) and a switching material layer (116), and the plurality of cell blocks (BLK) are provided in a first horizontal direction (x) and a second horizontal direction (y) intersecting the first horizontal direction; and
a gate stack structure (120) comprising a plurality of gate electrodes (122) and a plurality of interlayer insulating layers (124) that are alternately stacked in the vertical direction along sidewalls of the plurality of electrode structures (110),
wherein each of the plurality of gate electrodes (122) comprises a pad part (PEP, POP) and a plurality of plate electrodes (PE1, PE2; PES, PET; POS, POT) spaced apart from each other in a horizontal direction,
**characterised in that**
at least one plate electrode among the plurality of plate electrodes is connected to the switching material layer (116) of the plurality of electrode structures (110) in each of two of the plurality of cell blocks (BLK) in the first horizontal direction and at least two of the plurality of cell blocks (BLK) in the second horizontal direction.

2. The semiconductor memory device of claim 1, wherein, for each of the plurality of gate electrodes (122), each of the plurality of plate electrodes (PE1, PE2) comprises:
at least two shaft parts (PES, POS) extending from the pad part (PEP, POP); and
a plurality of sawtooth parts (PET, POT) extending from each of the at least two shaft parts, and
wherein each of the plurality of sawtooth parts extends into the folding structure.

3. The semiconductor memory device of claim 2, wherein the pad part extends in the second horizontal direction, the at least two shaft parts extend in the first horizontal direction, and the plurality of sawtooth parts extend in the second horizontal direction.

4. The semiconductor memory device of claim 2 or 3, wherein, for each of the plurality of gate electrodes (122), two plate electrodes among the plurality of plate electrodes (PE1, PE2) are connected to the switching material layer (116) of the plurality of electrode structures (110).

5. The semiconductor memory device of claim 4, wherein, for each of the plurality of gate electrodes (122), each of the two plate electrodes (PE1, PE2) is connected to the switching material layer (116) of the plurality of electrode structures (110) in two cell blocks among the plurality of cell blocks that are provided in the first horizontal direction and two cell blocks among the plurality of cell blocks that are provided in the second horizontal direction.

6. The semiconductor memory device of any preceding claim, wherein legs of the U-shaped structures are aligned in the second horizontal direction.

7. The semiconductor memory device of any preceding claim, wherein, for each of the plurality of gate electrodes (122), the at least one plate electrode (PE1, PE2) is connected to the switching material layer (116) and at least two of cell blocks provided in the second horizontal direction, among the plurality of cell blocks.

8. The semiconductor memory device of any preceding claim, wherein the plurality of cell blocks (BLK) comprises a first cell block (BLK-1; BLK-3) and a second cell block (BLK-2; BLK-4) adjacent to each other in the second horizontal direction (y), and
wherein the folding structure of the first cell block and the folding structure of the second cell block are symmetrically provided with respect to a straight line extending in the first horizontal direction (x).

9. The semiconductor memory device of any of claims 1 to 7, wherein the plurality of cell blocks (BLK) comprises a first cell block (BLK-1; BLK-2; BLK-3; BLK-4) and a second cell block (BLK-1; BLK-2; BLK-3; BLK-4) adjacent to each other in the first horizontal direction (x), and
wherein the folding structure of the first cell block and the folding structure of the second cell block are symmetrically provided with respect to a straight line extending in the second horizontal direction (y).

## Patentansprüche

1. Halbleiterspeichervorrichtung, umfassend:
eine Vielzahl von Zellblöcken (BLK), die jeweils eine Faltstruktur (FS) umfassen, in der abwechselnd eine Vielzahl von Elektrodenstrukturen (110) und eine Vielzahl von Isolierstrukturen (150) angeordnet sind, wobei sich jede von der Vielzahl von Elektrodenstrukturen (110) und jede von der Vielzahl von Isolierstrukturen (150) in vertikaler Richtung (z) erstreckt und so miteinander verbunden sind, dass in einer Draufsicht mindestens zwei U-förmige Strukturen vorgesehen sind, wobei die Vielzahl von Elektrodenstrukturen (110) eine vertikale Elektrode (112) und eine Schaltmaterialschicht (116) umfassen und die Vielzahl von Zellenblöcken (BLK) in einer ersten horizontalen Richtung (x) und einer zweiten horizontalen Richtung (y), die die erste horizontale Richtung schneidet, angeordnet sind; und
eine Gate-Stack-Struktur (120), die eine Vielzahl von Gate-Elektroden (122) und eine Vielzahl von Zwischenschicht-Isolierschichten (124) umfasst, die in vertikaler Richtung entlang von Seitenwänden der Vielzahl von Elektrodenstrukturen (110) abwechselnd gestapelt sind,
wobei jede von der Vielzahl von Gate-Elektroden (122) einen Flächenteil (PEP, POP) und eine Vielzahl von Plattenelektroden (PE1, PE2; PES, PET; POS, POT) umfasst, die in horizontaler Richtung voneinander beabstandet sind,
**dadurch gekennzeichnet, dass**
mindestens eine Plattenelektrode von der Vielzahl von Plattenelektroden mit der Schaltmaterialschicht (116) von der Vielzahl von Elektrodenstrukturen (110) in jeweils zwei der Vielzahl von Zellenblöcken (BLK) in der ersten horizontalen Richtung und mindestens zwei der Vielzahl von Zellenblöcken (BLK) in der zweiten horizontalen Richtung verbunden ist.

2. Halbleiterspeichervorrichtung nach Anspruch 1, wobei für jede der Vielzahl von Gate-Elektroden (122) jede der Vielzahl von Plattenelektroden (PE1, PE2) Folgendes umfasst:
mindestens zwei Rumpfteile (PES, POS), die sich vom Flächenteil (PEP, POP) aus erstrecken; und
eine Vielzahl von Sägezahnteilen (PET, POT), die sich von jedem der mindestens zwei Rumpfteile aus erstrecken, und
wobei sich jede der Vielzahl von Sägezahnteilen in die Faltstruktur hinein erstreckt.

3. Halbleiterspeichervorrichtung nach Anspruch 2, wobei sich der Flächenteil in die zweite horizontale Richtung erstreckt, sich die mindestens zwei Rumpfteile in die erste horizontale Richtung erstrecken und sich die Vielzahl von Sägezahnteilen in die zweite horizontale Richtung erstrecken.

4. Halbleiterspeichervorrichtung nach Anspruch 2 oder 3, wobei für jede der Vielzahl von Gate-Elektroden (122) zwei Plattenelektroden von der Vielzahl von Plattenelektroden (PE1, PE2) mit der Schaltmaterialschicht (116) der Vielzahl von Elektrodenstrukturen (110) verbunden sind.

5. Halbleiterspeichervorrichtung nach Anspruch 4, wobei für jede der Vielzahl von Gate-Elektroden (122) jede der beiden Plattenelektroden (PE1, PE2) mit der Schaltmaterialschicht (116) der Vielzahl von Elektrodenstrukturen (110) in zwei Zellenblöcken von der Vielzahl von in der ersten horizontalen Richtung angeordneten Zellenblöcken und in zwei Zellenblöcken von der Vielzahl von in der zweiten horizontalen Richtung angeordneten Zellenblöcken verbunden ist.

6. Halbleiterspeichervorrichtung nach einem vorstehenden Anspruch, wobei Schenkel der U-förmigen Strukturen in der zweiten horizontalen Richtung ausgerichtet sind.

7. Halbleiterspeichervorrichtung nach einem vorstehenden Anspruch, wobei für jede der Vielzahl von Gate-Elektroden (122) die mindestens eine Plattenelektrode (PE1, PE2) mit der Schaltmaterialschicht (116) und mindestens zwei der in der zweiten horizontalen Richtung angeordneten Zellenblöcke von der Vielzahl von Zellenblöcken verbunden ist.

8. Halbleiterspeichervorrichtung nach einem vorstehenden Anspruch, wobei die Vielzahl von Zellenblöcken (BLK) einen ersten Zellenblock (BLK-1; BLK-3) und einen zweiten Zellenblock (BLK-2; BLK-4) umfassen, die in der zweiten horizontalen Richtung (y) aneinandergrenzen, und
wobei die Faltstruktur des ersten Zellenblocks und die Faltstruktur des zweiten Zellenblocks symmetrisch zu einer geraden Linie angeordnet sind, die sich in der ersten horizontalen Richtung (x) erstreckt.

9. Halbleiterspeichervorrichtung nach einem der Ansprüche 1 bis 7, wobei die Vielzahl von Zellenblöcken (BLK) einen ersten Zellenblock (BLK-1; BLK-2; BLK-3; BLK-4) und einen zweiten Zellenblock (BLK-1; BLK-2; BLK-3; BLK-4) umfassen, die in der ersten horizontalen Richtung (x) aneinandergrenzen, und
wobei die Faltstruktur des ersten Zellenblocks und die Faltstruktur des zweiten Zellenblocks symmetrisch zu einer geraden Linie angeordnet sind, die sich in der zweiten horizontalen Richtung (y) erstreckt.

## Revendications

1. Dispositif de mémoire semi-conducteur comprenant :
une pluralité de blocs cellulaires (BLK), chacun comprenant une structure pliable (FS) dans laquelle une pluralité de structures d'électrodes (110) et une pluralité de structures isolantes (150) sont disposées alternativement, dans lequel chacune de la pluralité de structures d'électrodes (110) et chacune de la pluralité de structures isolantes (150) s'étendent dans une direction verticale (z) et sont reliées entre elles de manière à présenter au moins deux structures en forme de U en vue en plan, la pluralité de structures d'électrodes (110) comprennent une électrode verticale (112) et une couche de matériau de commutation (116), et la pluralité de blocs cellulaires (BLK) sont disposés dans une première direction horizontale (x) et une seconde direction horizontale (y) croisant la première direction horizontale ; et
une structure d'empilement de grille (120) comprenant une pluralité d'électrodes de grille (122) et une pluralité de couches isolantes intermédiaires (124) qui sont empilées alternativement dans la direction verticale le long de parois latérales de la pluralité de structures d'électrodes (110),
dans lequel chacune de la pluralité d'électrodes de grille (122) comprend une partie de coussinet (PEP, POP) et une pluralité d'électrodes de plaque (PE1, PE2 ; PES, PET ; POS, POT) espacées les unes des autres dans une direction horizontale,
**caractérisé en ce que**
au moins une électrode de plaque parmi la pluralité d'électrodes de plaque est reliée à la couche de matériau de commutation (116) de la pluralité de structures d'électrodes (110) dans chacun de deux de la pluralité de blocs cellulaires (BLK) dans la première direction horizontale et dans au moins deux de la pluralité de blocs cellulaires (BLK) dans la seconde direction horizontale.

2. Dispositif de mémoire semi-conducteur selon la revendication 1, dans lequel, pour chacune de la pluralité d'électrodes de grille (122), chacune de la pluralité d'électrodes de plaque (PE1, PE2) comprend :
au moins deux parties d'arbre (PES, POS) s'étendant à partir de la partie de coussinet (PEP, POP) ; et
une pluralité de pièces en dents de scie (PET, POT) s'étendant de chacune des au moins deux parties d'arbre, et
dans lequel chacune de la pluralité de parties en dents de scie s'étend dans la structure de pliage.

3. Dispositif de mémoire semi-conducteur selon la revendication 2, dans lequel la partie de coussinet s'étend dans la seconde direction horizontale, les au moins deux parties d'arbre s'étendent dans la première direction horizontale et la pluralité de parties en dents de scie s'étendent dans la seconde direction horizontale.

4. Dispositif de mémoire semi-conducteur selon la revendication 2 ou 3, dans lequel, pour chacune de la pluralité d'électrodes de grille (122), deux électrodes de plaque parmi la pluralité d'électrodes de plaque (PE1, PE2) sont reliées à la couche de matériau de commutation (116) de la pluralité de structures d'électrodes (110).

5. Dispositif de mémoire semi-conducteur selon la revendication 4, dans lequel, pour chacune de la pluralité d'électrodes de grille (122), chacune des deux électrodes de plaque (PE1, PE2) est reliée à la couche de matériau de commutation (116) de la pluralité de structures d'électrodes (110) dans deux blocs cellulaires parmi la pluralité de blocs cellulaires qui sont fournis dans la première direction horizontale et deux blocs cellulaires parmi la pluralité de blocs cellulaires qui sont fournis dans la seconde direction horizontale.

6. Dispositif de mémoire semi-conducteur selon une quelconque revendication précédente, dans lequel les branches des structures en forme de U sont alignées dans la seconde direction horizontale.

7. Dispositif de mémoire semi-conducteur selon une quelconque revendication précédente, dans lequel, pour chacune de la pluralité d'électrodes de grille (122), la au moins une électrode de plaque (PE1, PE2) est reliée à la couche de matériau de commutation (116) et à au moins deux blocs cellulaires disposés dans la seconde direction horizontale, parmi la pluralité de blocs cellulaires.

8. Dispositif de mémoire semi-conducteur selon une quelconque revendication précédente, dans lequel la pluralité de blocs cellulaires (BLK) comprend un premier bloc cellulaire (BLK-1 ; BLK-3) et un second bloc cellulaire (BLK-2 ; BLK-4) adjacents l'un à l'autre dans la seconde direction horizontale (y), et
dans lequel la structure de pliage du premier bloc cellulaire et la structure de pliage du second bloc cellulaire sont disposées symétriquement par rapport à une ligne droite s'étendant dans la première direction horizontale (x).

9. Dispositif de mémoire semi-conducteur selon l'une quelconque des revendications 1 à 7, dans lequel la pluralité de blocs cellulaires (BLK) comprend un premier bloc cellulaire (BLK-1 ; BLK-2 ; BLK-3 ; BLK-4) et un second bloc cellulaire (BLK-1 ; BLK-2 ; BLK-3 ; BLK-4) adjacents l'un à l'autre dans la première direction horizontale (x), et
dans lequel la structure de pliage du premier bloc cellulaire et la structure de pliage du second bloc cellulaire sont disposées symétriquement par rapport à une ligne droite s'étendant dans la seconde direction horizontale (y).
